# EUROPEAN PATENT APPLICATION

(11) **EP 4 249 967 A1**
(43) Date of publication of application: **27.09.2023**
(21) Application number: 21894445.2
(22) Date of filing: 29.10.2021
(51) Int. Cl.: G02B 3/00, H01S 5/022, H01S 5/02253, H01S 5/026

(54) **LIGHT-EMITTING DEVICE AND MANUFACTURING METHOD THEREFOR**

(30) Priority: 20.11.2020 JP 2020193598
(71) Applicant: Sony Semiconductor Solutions Corporation, Atsugi-shi, Kanagawa 243-0014 (JP)
(72) Inventor: MOGI, Hideaki, Atsugi-shi, Kanagawa 243-0014 (JP); NAKAMURA, Masashi, Atsugi-shi, Kanagawa 243-0014 (JP); IWASHITA, Jun, Atsugi-shi, Kanagawa 243-0014 (JP); KATO, Hiroshi, Atsugi-shi, Kanagawa 243-0014 (JP)
(74) Representative: Müller Hoffmann & Partner
(86) International application number: PCT/JP2021/039962
(87) International publication number: WO 2022/107571

(57) **Abstract**

Provided are a light emitting device capable of providing lenses or light emitting elements on a substrate in a suitable manner, and a method for manufacturing the light emitting device.

A light emitting device of the present disclosure includes: a first substrate; a light emitting element provided on a lower surface of the first substrate; a lens provided on an upper surface of the first substrate; a first protrusion provided on the upper surface of the first substrate; and a first film provided on the upper surface of the first substrate, the first film including a first portion disposed on the lens or forming the lens, and a second portion disposed on the first protrusion or forming the first protrusion, in which a height of an uppermost portion of the first portion is equal to or less than a height of an uppermost portion of the second portion.

## Description

### TECHNICAL FIELD

The present disclosure relates to a light emitting device and a method for manufacturing the same.

### BACKGROUND ART

As a type of semiconductor laser, a surface emitting laser such as a vertical cavity surface emitting laser (VCSEL) is known. In general, in a light emitting device using a surface emitting laser, a plurality of light emitting elements is provided in a two-dimensional array on a front surface or a back surface of a substrate.

### CITATION LIST

### PATENT DOCUMENT

Patent Document 1: Japanese Patent Application Laid-Open No. 2004-526194

### SUMMARY OF THE INVENTION

### PROBLEMS TO BE SOLVED BY THE INVENTION

In the light emitting device described above, for example, a plurality of light emitting elements is provided on the front surface of the substrate, and a plurality of lenses is provided on the back surface of the substrate. In this case, various problems concerning these lenses and light emitting elements may occur. For example, when the substrate described above is adsorbed and mounted on another substrate, pressure may be applied to the lenses or the light emitting elements to damage the lenses or the light emitting elements, or the substrate described above may be hardly adsorbed due to the lenses or the light emitting elements.

Therefore, the present disclosure provides a light emitting device capable of providing lenses or light emitting elements on a substrate in a suitable manner, and a method for manufacturing the light emitting device.

### SOLUTIONS TO PROBLEMS

A light emitting device according to a first aspect of the present disclosure includes: a first substrate; a light emitting element provided on a lower surface of the first substrate; a lens provided on an upper surface of the first substrate; a first protrusion provided on the upper surface of the first substrate; and a first film provided on the upper surface of the first substrate, the first film including a first portion disposed on the lens or forming the lens, and a second portion disposed on the first protrusion or forming the first protrusion, in which a height of an uppermost portion of the first portion is equal to or less than a height of an uppermost portion of the second portion. As a result, the lens can be provided in a suitable manner on the first substrate. For example, when the first substrate is adsorbed and mounted on the second substrate, the first substrate is held by adsorption in the second portion, so that it is possible to suppress damage to the lens due to application of pressure to the lens and to suppress difficulty in adsorption of the first substrate due to the lens.

Furthermore, in the first aspect, the lens may be a convex lens, a concave lens, a Fresnel lens, a binary lens, or a flat lens. As a result, for example, lenses of various shapes can be formed in a suitable manner on the first substrate.

Furthermore, in the first aspect, one or more of the light emitting elements may be provided on the lower surface of the first substrate, one or more of the lenses may be provided on the upper surface of the first substrate, and the light emitting element and the lens may correspond to each other at 1 : 1, N : 1, or 1 : N (N is an integer of 2 or more). As a result, for example, lenses of various sizes can be formed in a suitable manner on the first substrate.

Furthermore, in the first aspect, the first protrusion may have a shape annularly surrounding the lens. As a result, for example, the first protrusion can be arranged in a wide range around the lens.

Furthermore, the light emitting device of the first aspect may include a plurality of first protrusions provided on a plurality of corners or sides of the upper surface of the first substrate as the first protrusion. As a result, for example, the first protrusion can be arranged only in the vicinity of the corner or the vicinity of the side of the upper surface of the first substrate.

Furthermore, in the first aspect, the first protrusion may have a linear shape extending along one side of the upper surface of the first substrate. As a result, for example, it is possible to arrange the first protrusion only in the vicinity of one side of the upper surface of the first substrate.

Furthermore, in the first aspect, the first protrusion may have an L-shape extending along two sides of the upper surface of the first substrate. As a result, for example, it is possible to arrange the first protrusion only in the vicinity of two sides of the upper surface of the first substrate.

Furthermore, in the first aspect, the first protrusion may include a dummy lens. As a result, for example, the first protrusion (dummy lens) can be easily formed simultaneously with the lens.

Furthermore, in the first aspect, the first film may be an antireflection film provided on the lens. As a result, for example, a portion in contact with a first substrate holding device that holds the first substrate can be used as the antireflection film.

Furthermore, in the first aspect, the first film may further include a light absorbing film, an inorganic film, or an organic film. As a result, for example, it is possible to prevent reflection of light from the light emitting element by the light absorbing property of the first film, to prevent warpage of the first substrate by the rigidity of the first film, and to disperse pressure on the first substrate by the elasticity of the first film.

Furthermore, in the first aspect, the light absorbing film, the inorganic film, or the organic film may be provided on the antireflection film. As a result, for example, the antireflection film and the light absorbing film, the inorganic film, or the organic film can be sequentially provided on the first substrate.

Furthermore, the light emitting device of the first aspect may further include a second protrusion provided on the lower surface of the first substrate, in which a height of a lowermost portion of the light emitting element may be equal to or higher than a height of a lowermost portion of the second protrusion. As a result, it is possible to provide the light emitting element on the first substrate in a suitable manner. For example, when the first substrate is adsorbed and mounted on the second substrate, by holding the first substrate by adsorption at the second protrusion, it is possible to suppress damage to the light emitting element due to application of pressure to the light emitting element and difficulty in adsorption of the first substrate due to the light emitting element.

Furthermore, in the first aspect, the second protrusion may have a shape annularly surrounding the light emitting element. As a result, for example, the second protrusion can be arranged in a wide range around the light emitting element.

Furthermore, the light emitting device of the first aspect may include a plurality of second protrusions provided on a plurality of corners or sides of the lower surface of the first substrate as the second protrusion. As a result, for example, the second protrusion can be arranged only in the vicinity of the corner or the vicinity of the side of the lower surface of the first substrate.

Furthermore, in the first aspect, the second protrusion may have a linear shape extending along one side of the lower surface of the first substrate. As a result, for example, it is possible to arrange the second protrusion only in the vicinity of one side of the lower surface of the first substrate.

Furthermore, in the first aspect, the second protrusion may include a dummy light emitting element. As a result, for example, the second protrusion (dummy light emitting element) can be easily formed simultaneously with the light emitting element.

Furthermore, the light emitting device of the first aspect may further include a second film provided on the lower surface of the first substrate and forming the second protrusion. As a result, for example, the second protrusion can be constituted by a material (second film) different from the material of the light emitting element.

Furthermore, in the first aspect, the second film may include a light absorbing film, an inorganic film, or an organic film. As a result, for example, it is possible to prevent reflection of light from the light emitting element by the light absorbing property of the second film, to prevent warpage of the first substrate by the rigidity of the second film, and to disperse pressure on the first substrate by the elasticity of the second film.

Furthermore, in the first aspect, the first substrate may be a semiconductor substrate containing gallium (Ga) and arsenic (As). As a result, for example, even in a case where a lens is formed on a sensitive GaAs substrate, it is possible to suppress damage to the lens.

Furthermore, in the first aspect, light emitted from the light emitting element may pass through the first substrate from the lower surface to the upper surface of the first substrate, and enters the lens. As a result, for example, it is possible to suppress damage to the lens in the backside emission type light emitting device.

Furthermore, the light emitting device of the first aspect may further include a second substrate on which the first substrate is mounted with the light emitting element interposed therebetween. As a result, for example, when the first substrate is mounted on the second substrate, it is possible to suppress damage to the lens due to application of pressure to the lens and to suppress the first substrate from being difficult to adsorb due to the lens.

Furthermore, in the first aspect, the second substrate may be a semiconductor substrate containing silicon (Si). As a result, for example, it is possible to form a circuit for the light emitting device on an inexpensive Si substrate while forming the light emitting element and the lens on a highly characteristic GaAs substrate.

A light emitting device according to a second aspect of the present disclosure includes: a first substrate; a light emitting element provided on a lower surface of the first substrate; a lens provided on an upper surface of the first substrate; and a first protrusion provided on the upper surface of the first substrate, in which a height of an uppermost portion of the lens is equal to or less than a height of an uppermost portion of the first protrusion. As a result, the lens can be provided in a suitable manner on the first substrate. For example, when the first substrate is adsorbed and mounted on the second substrate, by holding the first substrate by adsorption at the first protrusion, it is possible to suppress damage to the lens due to application of pressure to the lens and to suppress difficulty in adsorption of the first substrate due to the lens.

A method for manufacturing a light emitting device according to a third aspect of the present disclosure includes: forming a light emitting element on a lower surface of a first substrate; forming a lens on an upper surface of the first substrate; forming a first protrusion on the upper surface of the first substrate; and forming a first film including a first portion and a second portion on the upper surface of the first substrate, in which the first film is formed such that the first portion is disposed on the lens or forms the lens, and the second portion is disposed on the first protrusion or forms the first protrusion, and the first film is formed such that a height of an uppermost portion of the first portion is equal to or less than a height of an uppermost portion of the second portion. As a result, the lens can be provided in a suitable manner on the first substrate. For example, when the first substrate is adsorbed and mounted on the second substrate, the first substrate is held by adsorption in the second portion, so that it is possible to suppress damage to the lens due to application of pressure to the lens and to suppress difficulty in adsorption of the first substrate due to the lens.

Furthermore, the method for manufacturing the light emitting device according to the third aspect may further include dicing the first substrate into a plurality of chips after formation of the lens, the first protrusion, and the first film. As a result, for example, the first protrusion and the first film for holding the first substrate can be formed before dicing similarly to the lens, and the first protrusion and the first film can be easily formed in a process similar to the process of forming the lens.

Furthermore, in the third aspect, a part of the first protrusion may be formed in a dicing region of the first substrate. As a result, for example, it is possible to suppress the presence of the first protrusion from interfering with the arrangement of the lens.

Furthermore, in the third aspect, at least a part of the first protrusion may be formed in a region other than a dicing region of the first substrate. As a result, for example, the first protrusion can be left even after dicing, and the first protrusion and the second portion can be used for holding the first substrate after dicing.

Furthermore, the method for manufacturing the light emitting device according to the third aspect may further include: bringing a first substrate holding device into contact with the first film after dicing the first substrate and holding the first substrate by the first substrate holding device; and mounting the first substrate held by the first substrate holding device on a second substrate with the light emitting element interposed therebetween. As a result, for example, by using the first protrusion and the second portion for holding the first substrate, it is possible to suppress damage to the lens and difficulty in absorbing the first substrate due to the lens.

Furthermore, in the third aspect, the first substrate holding device may hold the first substrate to be in contact with the second portion and not to be in contact with the first portion. As a result, for example, by not using the lens or the first portion for holding the first substrate, it is possible to suppress damage to the lens and difficulty in absorbing the first substrate due to the lens.

Furthermore, in the third aspect, the method may further include forming a second protrusion on the lower surface of the first substrate, in which the light emitting element and the second protrusion are formed such that a height of a lowermost portion of the light emitting element is equal to or higher than a height of a lowermost portion of the second protrusion. As a result, it is possible to provide the light emitting element on the first substrate in a suitable manner. For example, when the first substrate is adsorbed and mounted on the second substrate, by holding the first substrate by adsorption at the second protrusion, it is possible to suppress damage to the light emitting element due to application of pressure to the light emitting element and difficulty in adsorption of the first substrate due to the light emitting element.

Furthermore, in the third aspect, the second protrusion may be formed to include a second film formed on the lower surface of the first substrate. As a result, for example, the second protrusion can be constituted by a material (second film) different from the material of the light emitting element.

Furthermore, the method for manufacturing the light emitting device of the third aspect may further include dicing the first substrate into a plurality of chips after formation of the light emitting element, the lens, the first protrusion, the first film, and the second protrusion. As a result, for example, the second protrusion for holding the first substrate can be formed before dicing similarly to the light emitting element, and the second protrusion can be easily formed in a process similar to the process of forming the light emitting element.

Furthermore, the method for manufacturing the light emitting device according to the third aspect may further include: bringing a second substrate holding device into contact with the second protrusion after dicing the first substrate and holding the first substrate by the second substrate holding device; and mounting the first substrate held by the second substrate holding device on a second substrate with the light emitting element interposed therebetween. As a result, for example, by using the second protrusion for holding the first substrate, it is possible to suppress damage to the light emitting element and difficulty in absorbing the first substrate due to the light emitting element.

Furthermore, in the third aspect, the second substrate holding device may hold the first substrate to be in contact with the second protrusion and not to be in contact with the light emitting element. As a result, for example, by not using the light emitting element and the second protrusion for holding the first substrate, it is possible to suppress damage to the light emitting element and difficulty in adsorbing the first substrate due to the light emitting element.

A method for manufacturing a light emitting device according to a fourth aspect of the present disclosure includes: forming a light emitting element on a lower surface of a first substrate; forming a lens on an upper surface of the first substrate; and forming a first protrusion on the upper surface of the first substrate, in which the lens and the first protrusion are formed such that a height of an uppermost portion of the lens is equal to or less than a height of an uppermost portion of the first protrusion. As a result, the lens can be provided in a suitable manner on the first substrate. For example, when the first substrate is adsorbed and mounted on the second substrate, by holding the first substrate by adsorption at the first protrusion, it is possible to suppress damage to the lens due to application of pressure to the lens and to suppress difficulty in adsorption of the first substrate due to the lens.

### BRIEF DESCRIPTION OF DRAWINGS

Fig. 1 is a block diagram illustrating a configuration of a distance measuring device according to a first embodiment.
Fig. 2 is a cross-sectional view illustrating an example of a structure of the light emitting device of the first embodiment.
Fig. 3 is a cross-sectional view illustrating a structure of the light emitting device illustrated in B of Fig. 2.
Fig. 4 is a cross-sectional view and a plan view illustrating a structure of the light emitting device of the first embodiment.
Fig. 5 is a plan view and a cross-sectional view illustrating a structure of a substrate of a light emitting device of a comparative example.
Fig. 6 is a plan view and a cross-sectional view illustrating a structure of a substrate of the light emitting device of the first embodiment.
Fig. 7 is a cross-sectional view illustrating a method for manufacturing the light emitting device of the comparative example.
Fig. 8 is a cross-sectional view illustrating the method for manufacturing the light emitting device of the first embodiment.
Fig. 9 is a plan view and a cross-sectional view illustrating a structure of a substrate of a light emitting device of a second embodiment.
Fig. 10 is a plan view and a cross-sectional view illustrating a structure of a substrate of a light emitting device of a third embodiment.
Fig. 11 is a plan view and a cross-sectional view illustrating a structure of a substrate of a light emitting device of a fourth embodiment.
Fig. 12 is a plan view and a cross-sectional view illustrating a structure of a substrate of a light emitting device of a fifth embodiment.
Fig. 13 is a plan view and a cross-sectional view illustrating a structure of a substrate of a light emitting device of a sixth embodiment.
Fig. 14 is a plan view and a cross-sectional view illustrating a structure of a substrate of a light emitting device of a seventh embodiment.
Fig. 15 is a plan view and a cross-sectional view illustrating a structure of a substrate of a light emitting device of an eighth embodiment.
Fig. 16 is a plan view and a cross-sectional view illustrating a structure of a substrate of a light emitting device of a ninth embodiment.
Fig. 17 is a cross-sectional view (1/2) illustrating an example of a structure of a substrate of a light emitting device of a 10th embodiment.
Fig. 18 is a cross-sectional view (2/2) illustrating an example of a structure of a substrate of the light emitting device of the 10th embodiment.
Fig. 19 is a cross-sectional view (1/2) illustrating an example of a structure of the light emitting device of the 10th embodiment.
Fig. 20 is a cross-sectional view (2/2) illustrating an example of a structure of the light emitting device of the 10th embodiment.
Fig. 21 is a plan view and a cross-sectional view illustrating a structure of a light emitting device of an 11th embodiment.
Fig. 22 is a plan view and a cross-sectional view illustrating a structure of a substrate of the light emitting device of the 11th embodiment.
Fig. 23 is a cross-sectional view illustrating the method for manufacturing the light emitting device of the 11th embodiment.
Fig. 24 is a cross-sectional view illustrating a structure of a light emitting device of a modification of the 11th embodiment.
Fig. 25 is a cross-sectional view illustrating a structure of a light emitting device of a modification of the 11th embodiment.
Fig. 26 is a plan view illustrating a structure of a substrate of a light emitting device of a 12th embodiment.
Fig. 27 is a plan view illustrating a structure of a substrate of a light emitting device of a 13th embodiment.
Fig. 28 is a plan view illustrating a structure of a substrate of a light emitting device of a 14th embodiment.
Fig. 29 is a plan view illustrating a structure of a substrate of a light emitting device of a 15th embodiment.
Fig. 30 is a cross-sectional view (1/2) illustrating a structure of a light emitting device of a 16th embodiment.
Fig. 31 is a cross-sectional view (2/2) illustrating a structure of the light emitting device of the 16th embodiment.
Fig. 32 is a cross-sectional view illustrating a first example of a method for manufacturing a light emitting device of a 17th embodiment.
Fig. 33 is a cross-sectional view illustrating a second example of the method for manufacturing the light emitting device of the 17th embodiment.
Fig. 34 is a cross-sectional view illustrating a third example of the method for manufacturing the light emitting device of the 17th embodiment.
Fig. 35 is a cross-sectional view illustrating a fourth example of the method for manufacturing the light emitting device of the 17th embodiment.

### MODE FOR CARRYING OUT THE INVENTION

Hereinafter, embodiments of the present disclosure will be described with reference to the drawings.

### (First Embodiment)

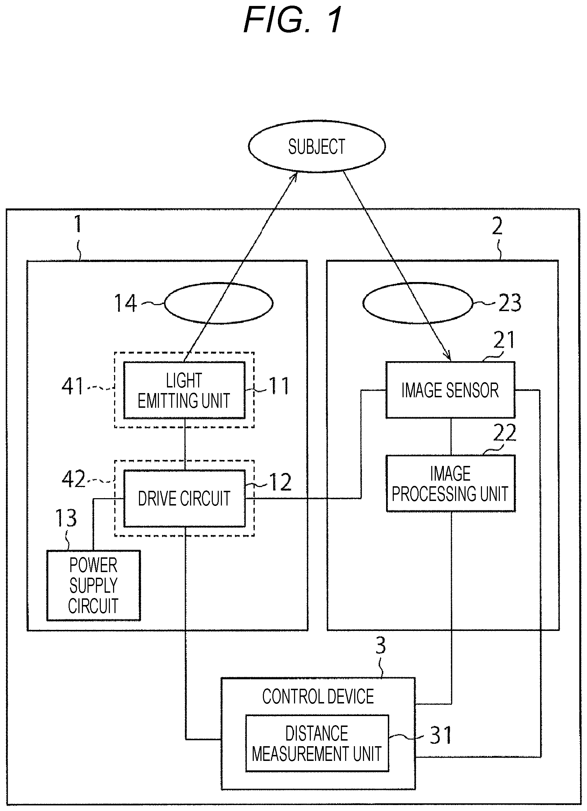

Fig. 1 is a block diagram illustrating a configuration of a distance measuring device according to a first embodiment.

The distance measuring device in Fig. 1 includes a light emitting device 1, an imaging device 2, and a control device 3. The distance measuring device in Fig. 1 irradiates a subject with light emitted from the light emitting device 1. The imaging device 2 receives light reflected by the subject and images the subject. The control device 3 measures (calculates) the distance to the subject using the image signal output from the imaging device 2. The light emitting device 1 functions as a light source for the imaging device 2 to image a subject.

The light emitting device 1 includes a light emitting unit 11, a drive circuit 12, a power supply circuit 13, and a light-emitting side optical system 14. The imaging device 2 includes an image sensor 21, an image processing unit 22, and an imaging side optical system 23. The control device 3 includes a distance measurement unit 31.

The light emitting unit 11 emits laser light for irradiating the subject. As described later, the light emitting unit 11 of the present embodiment includes a plurality of light emitting elements arranged in a two-dimensional array, and each light emitting element has a vertical cavity surface emitting laser (VCSEL) structure. The subject is irradiated with light emitted from these light emitting elements. As illustrated in Fig. 1, the light emitting unit 11 of the present embodiment is provided in a chip called a laser diode (LD) chip 41.

The drive circuit 12 is an electric circuit that drives the light emitting unit 11. The power supply circuit 13 is an electric circuit that generates a power supply voltage of the drive circuit 12. In the distance measuring device of Fig. 1, for example, the power supply circuit 13 generates a power supply voltage from an input voltage supplied from a battery in the distance measuring device, and the drive circuit 12 drives the light emitting unit 11 using the power supply voltage. As illustrated in Fig. 1, the drive circuit 12 of the present embodiment is provided in a substrate called a laser diode driver (LDD) substrate 42.

The light-emitting side optical system 14 includes various optical elements, and irradiates the subject with light from the light emitting unit 11 via these optical elements. Similarly, the imaging side optical system 23 includes various optical elements, and receives light from the subject via these optical elements.

The image sensor 21 receives light from the subject via the imaging side optical system 23, and converts the light into an electric signal by photoelectric conversion. The image sensor 21 is, for example, a charge coupled device (CCD) sensor or a complementary metal oxide semiconductor (CMOS) sensor. The image sensor 21 of the present embodiment converts the electronic signal described above from an analog signal to a digital signal by analog to digital (A/D) conversion, and outputs an image signal as a digital signal to the image processing unit 22. Furthermore, the image sensor 21 of the present embodiment outputs the frame synchronization signal to the drive circuit 12, and the drive circuit 12 causes the light emitting unit 11 to emit light at a timing corresponding to the frame period in the image sensor 21 on the basis of the frame synchronization signal.

The image processing unit 22 performs various types of image processing on the image signal output from the image sensor 21. The image processing unit 22 includes, for example, an image processing processor such as a digital signal processor (DSP).

The control device 3 controls various operations of the distance measuring device in Fig. 1, and controls, for example, a light emitting operation of the light emitting device 1 and an imaging operation of the imaging device 2. The control device 3 includes, for example, a central processing unit (CPU), a read only memory (ROM), a random access memory (RAM), and the like.

The distance measurement unit 31 measures the distance to the subject on the basis of the image signal output from the image sensor 21 and subjected to the image processing by the image processing unit 22. The distance measurement unit 31 employs, for example, a structured light (STL) method or a time of flight (ToF) method as a distance measurement method. The distance measurement unit 31 may further measure the distance between the distance measuring device and the subject for each portion of the subject on the basis of the image signal described above to specify the three-dimensional shape of the subject.

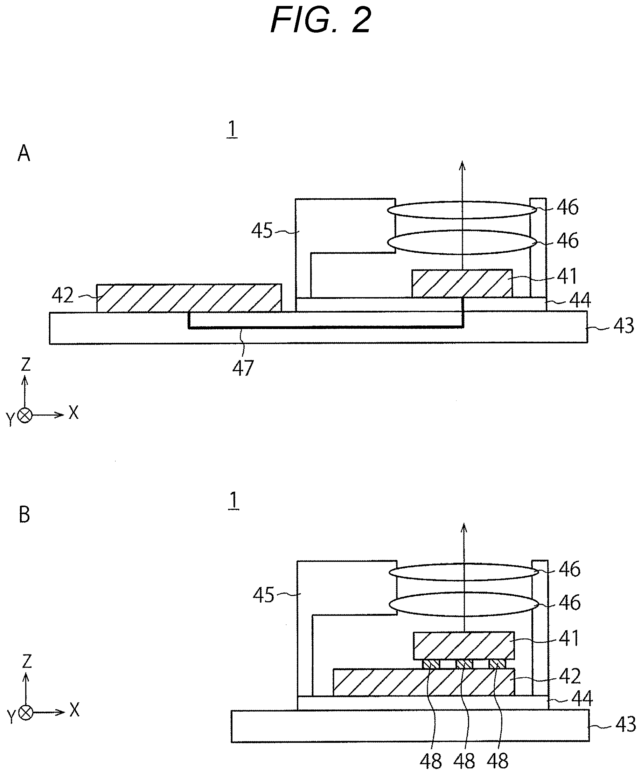

Fig. 2 is a cross-sectional view illustrating an example of a structure of the light emitting device 1 of the first embodiment.

A of Fig. 2 illustrates a first example of the structure of the light emitting device 1 of the present embodiment. The light emitting device 1 of this example includes the above-described LD chip 41 and LDD substrate 42, a mounting substrate 43, a heat dissipation substrate 44, a correction lens holding unit 45, one or more of correction lenses 46, and wiring 47.

A of Fig. 2 illustrates an X axis, a Y axis, and a Z axis perpendicular to each other. The X direction and the Y direction correspond to a lateral direction (horizontal direction), and the Z direction corresponds to a longitudinal direction (vertical direction). Furthermore, the +Z direction corresponds to the upward direction, and the -Z direction corresponds to the downward direction. The -Z direction may strictly match the gravity direction, or may not strictly match the gravity direction.

The LD chip 41 is disposed on the mounting substrate 43 with the heat dissipation substrate 44 interposed therebetween, and the LDD substrate 42 is also disposed on the mounting substrate 43. The mounting substrate 43 is, for example, a printed board. The image sensor 21 and the image processing unit 22 in Fig. 1 are also arranged on the mounting substrate 43 of the present embodiment. The heat dissipation substrate 44 is, for example, a ceramic substrate such as an Al₂O₃ (aluminum oxide) substrate or an AlN (aluminum nitride) substrate.

The correction lens holding unit 45 is disposed on the heat dissipation substrate 44 so as to surround the LD chip 41, and holds one or more of correction lenses 46 above the LD chip 41. These correction lenses 46 are included in the above-described light-emitting side optical system 14 (Fig. 1). The light emitted from the light emitting unit 11 (Fig. 1) in the LD chip 41 is corrected by these correction lenses 46 and then irradiated to the subject (Fig. 1). A of Fig. 2 illustrates two correction lenses 46 held by the correction lens holding unit 45 as an example.

The wiring 47 is provided on the front surface, the back surface, the inside, or the like of the mounting substrate 43, and electrically connects the LD chip 41 and the LDD substrate 42. The wiring 47 is, for example, a printed wiring provided on the front surface or the back surface of the mounting substrate 43 or a via wiring penetrating the mounting substrate 43. The wiring 47 of the present embodiment further passes through the inside or the vicinity of the heat dissipation substrate 44.

B of Fig. 2 illustrates a second example of the structure of the light emitting device 1 of the present embodiment. The light emitting device 1 of this example includes the same components as those of the light emitting device 1 of the first example, but includes bumps 48 instead of the wiring 47.

In B of Fig. 2, the LDD substrate 42 is disposed on the heat dissipation substrate 44, and the LD chip 41 is disposed on the LDD substrate 42. By disposing the LD chip 41 on the LDD substrate 42 in this manner, the size of the mounting substrate 43 can be reduced as compared with the case of the first example. In B of Fig. 2, the LD chip 41 is disposed on the LDD substrate 42 with the bumps 48 interposed therebetween, and is electrically connected to the LDD substrate 42 by the bumps 48. The bumps 48 are constituted by, for example, gold (Au).

Hereinafter, the light emitting device 1 of the present embodiment will be described as having the structure of the second example illustrated in B of Fig. 2. However, the following description is also applicable to the light emitting device 1 having the structure of the first example except for the description of the structure specific to the second example.

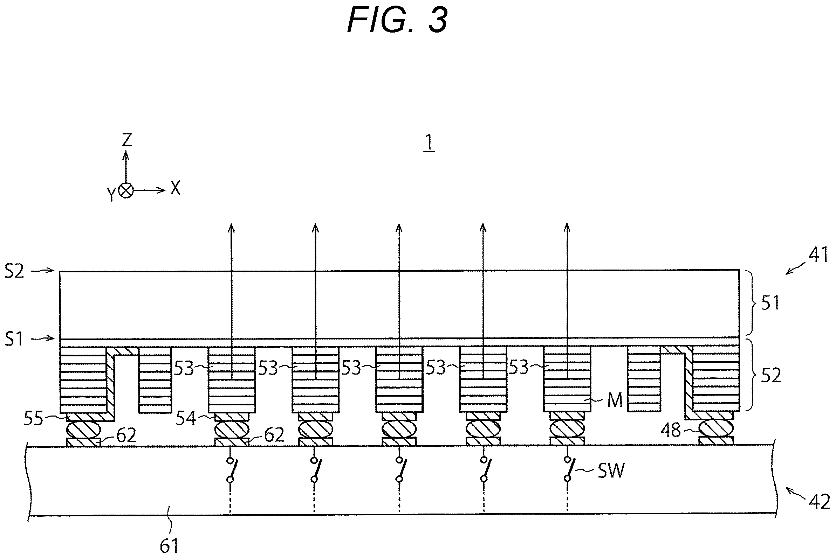

Fig. 3 is a cross-sectional view illustrating a structure of the light emitting device 1 illustrated in B of Fig. 2.

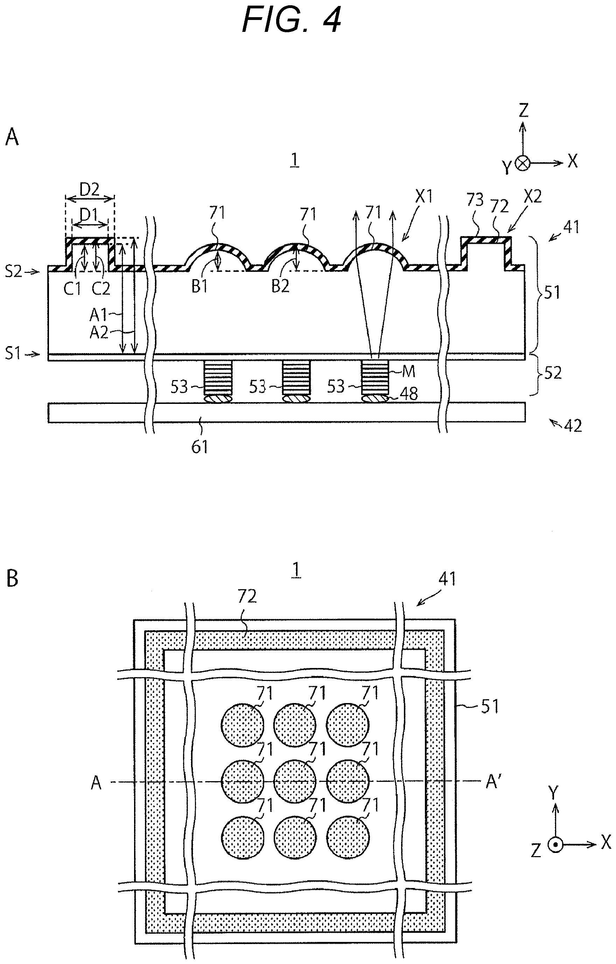

Fig. 3 illustrates cross sections of the LD chip 41 and the LDD substrate 42 in the light emitting device 1. As illustrated in Fig. 3, the LD chip 41 includes a substrate 51, a laminated film 52, a plurality of light emitting elements 53, a plurality of anode electrodes 54, and a plurality of cathode electrodes 55. Furthermore, the LDD substrate 42 includes a substrate 61 and a plurality of connection pads 62. The substrate 51 is an example of a first substrate of the present disclosure, and the substrate 61 is an example of a second substrate of the present disclosure. Note that, in Fig. 3, illustration of a lens 71, a protrusion 72, and an antireflection film 73 to be described later is omitted (see Fig. 4).

The substrate 51 is, for example, a compound semiconductor substrate such as a GaAs (gallium arsenide) substrate. Fig. 3 illustrates a front surface S1 of the substrate 51 facing the -Z direction and a back surface S2 of the substrate 51 facing the +Z direction. In Fig. 3, the front surface S1 is a lower surface of the substrate 51, and the back surface S2 is an upper surface of the substrate 51.

The laminated film 52 includes a plurality of layers laminated on the front surface S1 of the substrate 51. Examples of these layers include an n-type semiconductor layer, an active layer, a p-type semiconductor layer, a light reflecting layer, and an insulating layer having a light emission window. The laminated film 52 includes a plurality of mesa portions M protruding in the -Z direction. Parts of these mesa portions M are a plurality of light emitting elements 53.

The light emitting elements 53 are provided on the front surface S1 of the substrate 52 as parts of the laminated film 52. The light emitting elements 53 of the present embodiment have a VCSEL structure and emit light in the +Z direction. As illustrated in Fig. 3, the light emitted from the light emitting elements 53 passes through the substrate 51 from the front surface S1 to the back surface S2 of the substrate 51, and enters the above-described correction lenses 46 (Fig. 2) from the substrate 51. As described above, the LD chip 41 of the present embodiment is a backside emission type VCSEL chip.

The anode electrodes 54 are formed on the lower surface of the light emitting element 53. The cathode electrodes 55 are formed on the lower surface of the mesa portions M other than the light emitting elements 53, and extend from the lower surface of the mesa portions M to the lower surface of the laminated film 52 between the mesa portions M. Each light emitting element 53 emits light when a current flows between the corresponding anode electrode 54 and the corresponding cathode electrode 55.

As described above, the LD chip 41 is mounted on the LDD substrate 42 with the bumps 48 interposed therebetween, and is electrically connected to the LDD substrate 42 by the bumps 48. Specifically, the connection pads 62 are formed on the substrate 61 included in the LDD substrate 42, and the mesa portions M are arranged on the connection pads 62 with the bumps 48 interposed therebetween. Each mesa portion M is disposed on the bump 48 via the anode electrode 54 or the cathode electrode 55. The substrate 61 is, for example, a semiconductor substrate such as a silicon (Si) substrate.

The LDD substrate 42 includes the drive circuit 12 that drives the light emitting unit 11 (Fig. 1). Fig. 3 schematically illustrates a plurality of switches SW included in the drive circuit 12. Each switch SW is electrically connected to the corresponding light emitting element 53 via the bump 48. The drive circuit 12 of the present embodiment can control (turn on and off) these switches SW for each switch SW. Therefore, the drive circuit 12 can drive the plurality of light emitting elements 53 for each light emitting element 53. As a result, it is possible to precisely control the light emitted from the light emitting unit 11, for example, by causing only the light emitting elements 53 necessary for distance measurement to emit light. Such individual control of the light emitting elements 53 can be implemented by arranging the LDD substrate 42 below the LD chip 41, so that each light emitting element 53 is easily electrically connected to the corresponding switch SW.

Fig. 4 is a cross-sectional view and a plan view illustrating a structure of the light emitting device 1 of the first embodiment.

A of Fig. 4 illustrates cross sections of the LD chip 41 and the LDD substrate 42 in the light emitting device 1. As described above, the LD chip 41 includes the substrate 51, the laminated film 52, the plurality of light emitting elements 53, the plurality of anode electrodes 54, and the plurality of cathode electrodes 55, and the LDD substrate 42 includes the substrate 61 and the plurality of connection pads 62. However, in A of Fig. 4, illustration of the anode electrodes 54, the cathode electrodes 55, and the connection pads 62 is omitted.

The LD chip 41 of the present embodiment includes the plurality of light emitting elements 53 on the front surface S1 of the substrate 51, and a plurality of lenses 71, a protrusion 72, and an antireflection film 73 on the back surface S2 of the substrate 51. The protrusion 72 is an example of a first protrusion of the present disclosure. The antireflection film 73 is an example of a first film of the present disclosure.

Similarly to the light emitting elements 53, the lenses 71 are arranged in a two-dimensional array. The lenses 71 of the present embodiment correspond to the light emitting elements 53 on a one-to-one basis, and each of the lenses 71 is arranged in the +Z direction of one light emitting element 53. Furthermore, as illustrated in A of Fig. 4, the lenses 71 of the present embodiment are provided as part of the substrate 51 on the back surface S2 of the substrate 51. Specifically, the lenses 71 of the present embodiment are convex lenses, and are formed as part of the substrate 51 by etching processing of the back surface S2 of the substrate 51 into convex shapes. According to the present embodiment, by forming the lenses 71 by etching processing of the substrate 51, the lenses 71 can be easily formed. Note that details of an example of the lenses 71 other than the convex lenses and etching processing of the substrate 51 will be described later.

The protrusion 72 is provided on the back surface S2 of the substrate 51 and has a protruding shape protruding from the substrate 51 in the +Z direction. Therefore, a step due to the protrusion 72 is formed on the back surface S2 of the substrate 51. The protrusion 72 has a protruding shape similarly to the lenses 71 of the present embodiment which are convex lenses, but is not used as the lenses 71. As will be described later, the protrusion 72 of the present embodiment has a shape annularly surrounding all the lenses 71 on the substrate 51 (see B of Fig. 4). Furthermore, similarly to the lenses 71, the protrusion 72 of the present embodiment is provided as a part of the substrate 51 on the back surface S2 of the substrate 51. Therefore, according to the present embodiment, by forming the protrusion 72 by etching processing of the substrate 51, the protrusion 72 can be easily formed.

The antireflection film 73 is provided on the back surface S2 of the substrate 51 so as to cover the lenses 71 and the protrusion 72. Therefore, the antireflection film 73 includes a first portion X1 arranged on the lenses 71 and a second portion X2 arranged on the protrusion 72. The antireflection film 73 has a function of preventing light incident on the lenses 71 from the inside of the substrate 51 from being reflected to the inside of the substrate 51. The antireflection film 73 is, for example, a silicon oxide film. The antireflection film 73 has a uniform thickness in the present embodiment, but may have a non-uniform thickness.

The light emitted from the plurality of light emitting elements 53 described above passes through the substrate 51 from the front surface S1 to the back surface S2 of the substrate 51, and enters the plurality of lenses 71 described above. In the present embodiment, the light emitted from each light emitting element 53 is incident on one corresponding lens 71. As a result, the light emitted from the plurality of light emitting elements 53 described above can be molded for each lens 71. The light having passed through the plurality of lenses 71 described above passes through the correction lenses 46 (Fig. 2) and is irradiated to the subject (Fig. 1). Note that an example of a case where the light emitting elements 53 and the lenses 71 do not correspond to each other on a one-to-one basis will be described later.

Here, thicknesses A1, A2, B1, B2, C1, and C2 and widths D1 and D2 illustrated in A of Fig. 4 will be described.

In the present embodiment, the height of the uppermost portion of each lens 71 is equal to or less than the height of the uppermost portion of the protrusion 72. In other words, the Z coordinate of the uppermost portion of each lens 71 is equal to or less than the Z coordinate of the uppermost portion of the protrusion 72. Since each lens 71 of the present embodiment is a convex lens, the uppermost portion of each lens 71 is the top portion of each lens 71. Meanwhile, since the protrusion 72 of the present embodiment has a flat upper surface, the uppermost portion of the protrusion 72 is the upper surface of the protrusion 72. Therefore, in the present embodiment, the height of the top portion of each lens 71 is equal to or less than the height of the upper surface of the protrusion 72.

As a result, the height of the uppermost portion of the first portion X1 of the antireflection film 73 on each lens 71 is equal to or less than the height of the uppermost portion of the second portion X2 of the antireflection film 73 on the protrusion 72. The uppermost portion of the first portion X1 on each lens 71 exists above the top portion of each lens 71. Meanwhile, the uppermost portion of the second portion X2 on the protrusion 72 exists above the upper surface of the protrusion 72. Therefore, the height of the uppermost portion of the first portion X1 existing above the top portion of each lens 71 is equal to or less than the height of the uppermost portion of the second portion X2 existing above the upper surface of the protrusion 72.

The thicknesses A1, B1, and C1 represent the thicknesses of the substrate 51, the lenses 71, and the protrusion 72 in the Z direction, respectively. The width D1 represents the width of the protrusion 72 in the X direction in A of Fig. 4. The thickness A1 of the substrate 51 is, for example, 100 to 600 um. The thickness B1 of the lens 71 is, for example, 0.1 to 10 um. The thickness C1 of the protrusion 72 is, for example, 0.1 to 10 um. The width D1 of the protrusion 72 is, for example, 10 to 100 um. Furthermore, the thickness of the antireflection film 73 is, for example, 0.1 to 1 µm.

The thickness B1 of each lens 71 corresponds to the height of the uppermost portion of each lens 71 with respect to the flat portion of the back surface S2 of the substrate 51. Similarly, the thickness C1 of the protrusion 72 corresponds to the height of the uppermost portion of the protrusion 72 with respect to the flat portion of the back surface S2 of the substrate 51. Therefore, the fact that the height of the uppermost portion of each lens 71 is equal to or less than the height of the uppermost portion of the protrusion 72 can be rephrased as that the thickness B1 of each lens 71 is equal to or less than the thickness C1 of the protrusion 72 (B1 ≤ C1).

Moreover, thicknesses A2, B2, and C2 represent the total thickness of the substrate 51 and the antireflection film 73, the total thickness of the lens 71 and the antireflection film 73, and the total thickness of the protrusion 72 and the antireflection film 73, respectively. The width D2 represents the total width of the protrusion 72 and the antireflection film 74 in A of Fig. 4. The fact that the height of the uppermost portion of the first portion X1 on each lens 71 is equal to or less than the height of the uppermost portion of the second portion X2 on the protrusion 72 can be rephrased as that the total thickness B2 of each lens 71 and the antireflection film 73 is equal to or less than the total thickness C2 of the protrusion 72 and the antireflection film 73 (B2 ≤ C2).

When the light emitting device 1 of the present embodiment is manufactured, as described later, the substrate 51 is held by adsorbing the substrate 51, and the substrate 51 held by the adsorption is mounted on the substrate 61. At this time, if the substrate 51 is to be adsorbed by the first portion X1 on the lenses 71, pressure may be applied to the lenses 71 to damage the lenses 71, or the substrate 51 may be difficult to be adsorbed due to the lenses 71. However, since the height of the uppermost portion of the first portion X1 of the present embodiment is equal to or less than the height of the uppermost portion of the second portion X2, the substrate 51 can be adsorbed by the second portion X2 on the protrusion 72. As a result, it is possible to suppress damage to the lenses 71 due to application of pressure to the lenses 71 and difficulty in absorbing the substrate 51 due to the lenses 71.

Note that the plurality of lenses 71 described above has the same shape in the present embodiment, but may have different shapes. Furthermore, the protrusion 72 has a flat upper surface in the present embodiment, but may have a non-flat upper surface. Even in these cases, the effect described above can be obtained by setting the height of the uppermost portion of the first portion X1 on each lens 71 to be equal to or less than the height of the uppermost portion of the second portion X2 on the protrusion 72.

B of Fig. 4 illustrates a layout of the lenses 71 and the protrusion 72 provided on the back surface S2 of the substrate 51. In B of Fig. 4, the lenses 71 are arranged in a two-dimensional array on the back surface S2 of the substrate 51, specifically, arranged in a square lattice pattern. Furthermore, the protrusion 72 has a quadrangular annular shape extending along the four sides of the quadrangular back surface S2, and annularly surrounds all the lenses 71 on the substrate 51. Note that A of Fig. 4 illustrates a cross section taken along line A-A' illustrated in B of Fig. 4.

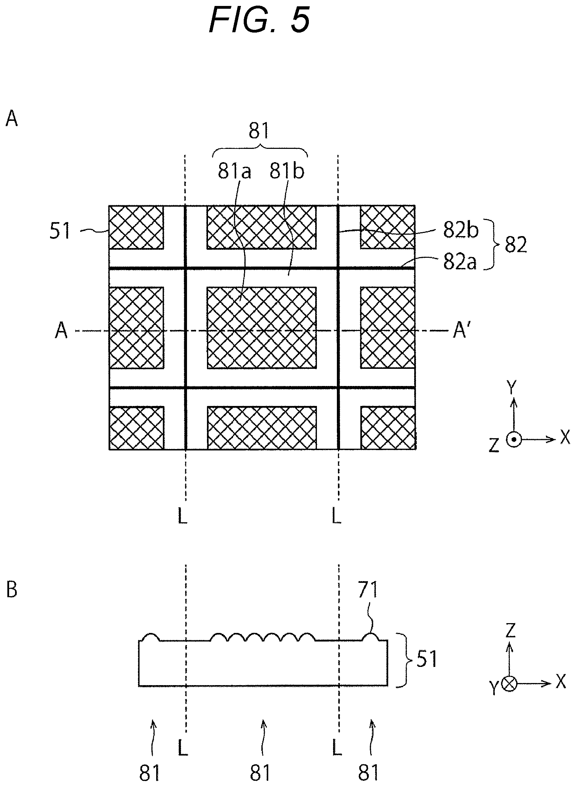

Next, with reference to Figs. 5 to 8, the light emitting device 1 of the first embodiment is compared with a light emitting device 1 of a comparative example. In the description of the light emitting device 1 of the present comparative example, the same reference numerals as those used in the description of the light emitting device 1 of the present embodiment are used.

Fig. 5 is a plan view and a cross-sectional view illustrating a structure of a substrate 51 of a light emitting device 1 of a comparative example. A of Fig. 5 is a plan view illustrating a structure of the substrate 51 before dicing, and B of Fig. 5 is a cross-sectional view taken along line A-A' illustrated in A of Fig. 5.

As illustrated in A and B of Fig. 5, the substrate 51 of the present comparative example includes a plurality of chip regions 81 and a scribe region (dicing region) 82. Each chip region 81 is a region that becomes one chip after dicing of the substrate 51. The scribe region 82 is a region cut at the time of dicing the substrate 51. The substrate 51 of the present comparative example is divided (diced) into the plurality of chip regions 81 by being cut in the scribe region 82.

Each chip region 81 has a rectangular (or square) planar shape, and includes a lens region 81a and a peripheral region 81b. The lens region 81a includes a plurality of lenses 71 arranged in a two-dimensional array (B of Fig. 5). The peripheral region 81b annularly surrounds the lens region 81a.

The scribe region 82 has a planar shape annularly surrounding the plurality of chip regions 81 described above for each of the chip regions 81, and includes a plurality of scribe lines (dicing lines) 82a extending in the X direction and a plurality of scribe lines 82b extending in the Y direction. The substrate 51 of the present comparative example is divided into the plurality of chip regions 81 by being cut by applying a dicer to these scribe lines 82a and 82b. A reference sign L indicates planes passing through the scribe lines 82b.

It should be noted that the substrate 51 of the present comparative example is not provided with the protrusion 72. Note that the antireflection film 73 is formed later on the substrate 51 illustrated in A and B of Fig. 5. That is, A and B of Fig. 5 illustrate the substrate 51 before the antireflection film 73 is formed.

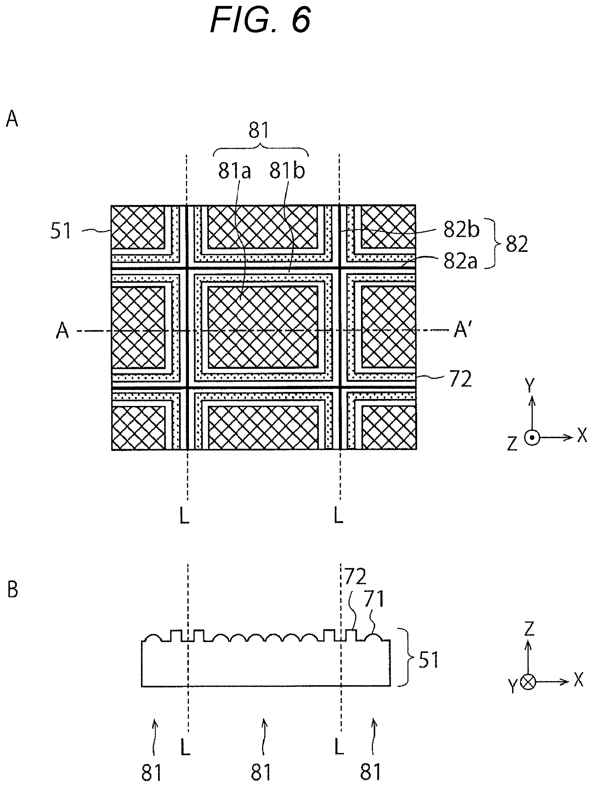

Fig. 6 is a plan view and a cross-sectional view illustrating a structure of the substrate 51 of the light emitting device 1 of the first embodiment. A of Fig. 6 is a plan view illustrating a structure of the substrate 51 before dicing, and B of Fig. 6 is a cross-sectional view taken along line A-A' illustrated in A of Fig. 6.

As illustrated in A and B of Fig. 6, the substrate 51 of the present embodiment includes a plurality of chip regions 81 and a scribe region 82. The structure of the chip regions 81 and the scribe region 82 of the present embodiment are substantially the same as the structure of the chip regions 81 and the scribe region 82 of the comparative example.

However, the substrate 51 of the present embodiment is provided with a plurality of protrusions 72. These protrusions 72 are provided in the chip regions 81 of the substrate 51, and specifically, one protrusion 72 is provided in one chip region 81 (A of Fig. 6). Each protrusion 72 is provided in the peripheral region 81b and has a planar shape annularly surrounding the lens region 81a. It should be noted that each protrusion 72 of the present embodiment is not provided in the scribe region 82 as illustrated in A and B of Fig. 6.

In A of Fig. 6, the ratios of the areas of the lens region 81a and the peripheral region 81b to the area of each chip region 81 are, for example, about 70% and about 30%, respectively. Furthermore, the ratio of the area of the protrusion 72 to the area of each chip region 81 is, for example, 1.5 to 30%. It similarly applies to the second to 17th embodiments described later. Note that the values of these ratios may be set to values different from the values described above.

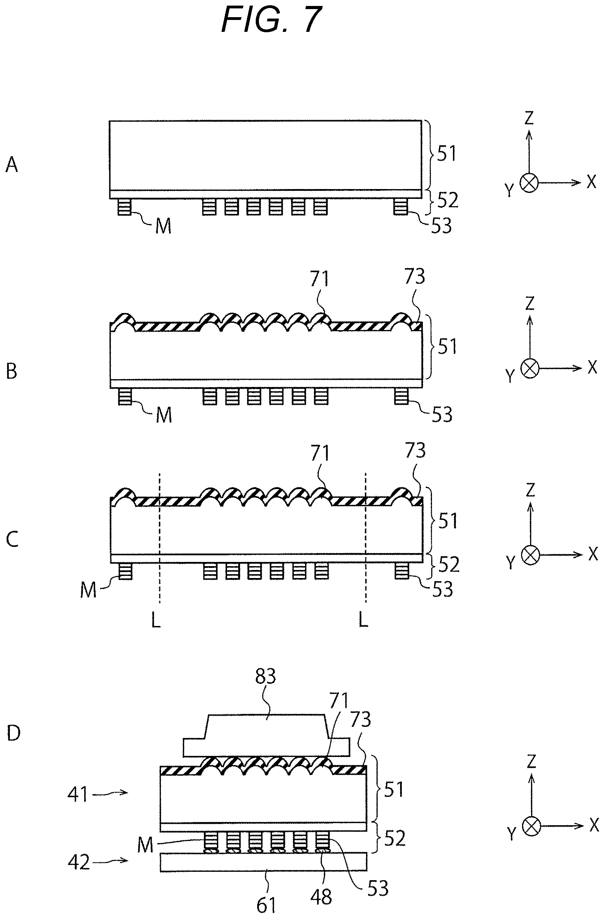

Fig. 7 is a cross-sectional view illustrating a method for manufacturing the light emitting device 1 of the comparative example.

First, the laminated film 52 is formed on the front surface S1 of the substrate 51, and the mesa portions M including the light emitting elements 53 are formed on the laminated film 52 (A of Fig. 7). Specifically, with the front surface S1 of the substrate 51 facing upward, the laminated film 52 and the mesa portions M are formed on the upper surface (front surface S1) of the substrate 51, and then the front surface S1 of the substrate 51 faces downward. In this way, as illustrated in A of Fig. 7, the laminated film 52 and the mesa portions M are formed on the lower surface (front surface S1) of the substrate 51. In the process of A of Fig. 7, the anode electrodes 54 and the cathode electrodes 55 are further formed on the front surface S1 of the substrate 51.

Next, the lenses 71 are formed on the back surface S2 (upper surface) of the substrate 51 by lithography and dry etching (B of Fig. 7). The lenses 71 of the present comparative example are formed as part of the substrate 51 on the back surface S2 of the substrate 51. Next, the antireflection film 73 is formed on the back surface S2 of the substrate 51 so as to cover the lenses 71 (B of Fig. 7).

Next, the substrate 51 is cut in the above-described scribe region 82 (C of Fig. 7). As a result, the substrate 51 is divided into the above-described plurality of chip regions 81 as illustrated in D of Fig. 7.

Next, the substrate 51 (chip) is held by a collet 83, and the substrate 51 held by the collet 83 is mounted on the substrate 61 (D of Fig. 7). Specifically, the mesa portions M provided on the substrate 51 are arranged on the substrate 61 with the anode electrodes 54 or the cathode electrodes 55 (not illustrated), the bumps 48, and the connection pads 62 (not illustrated) interposed therebetween. As a result, the substrate 51 is electrically connected to the substrate 61. In this way, the light emitting device 1 of the present comparative example is manufactured.

The collet 83 can hold the substrate 51 by absorbing the substrate 51 in contact with the exposed surface on the substrate 51. Since the exposed surface on the substrate 51 of the present comparative example is the upper surface of the antireflection film 73 on the substrate 51, the collet 83 is in contact with the upper surface of the antireflection film 73. The collet 83 is an example of a first substrate holding device of the present disclosure.

In the present comparative example, since the lenses 71 protrude in the +Z direction from the substrate 51, the antireflection film 73 on the lenses 71 protrudes in the +Z direction from the other portion of the antireflection film 73. Therefore, the collet 83 contacts the antireflection film 73 on the lenses 71. In general, the collet 83 is constituted by a hard material, and even when the collet 83 contacts the antireflection film 73 on the lenses 71, the shape of the collet 83 does not follow the uneven shape of the antireflection film 73 on the lenses 71. Therefore, when the collet 83 comes into contact with the antireflection film 73 on the lenses 71, pressure may be applied from the collet 83 to the lenses 71, and the lenses 71 may be damaged, or the substrate 51 may be hardly adsorbed by the collet 83 due to the lenses 71.

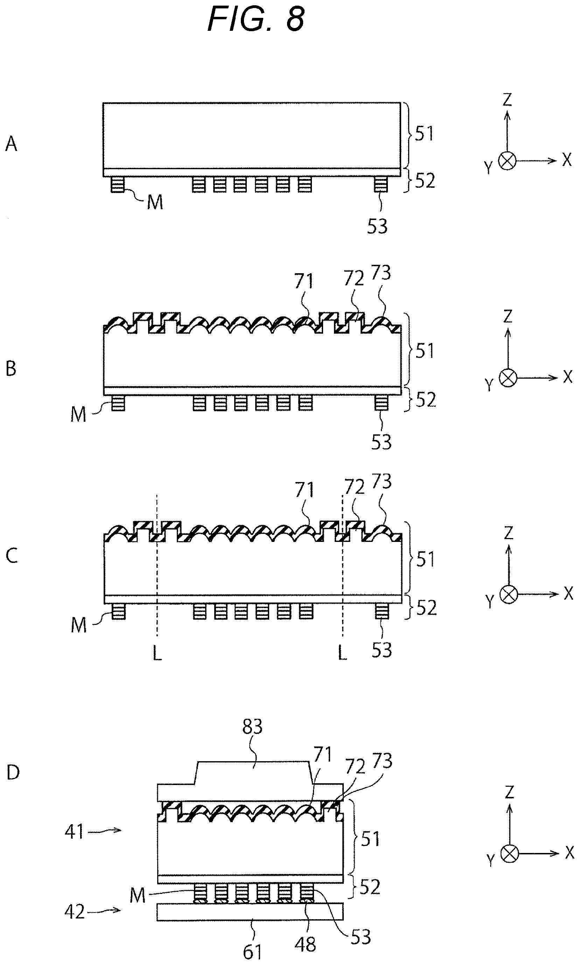

Fig. 8 is a cross-sectional view illustrating the method for manufacturing the light emitting device 1 of the first embodiment.

First, the laminated film 52 is formed on the front surface S1 of the substrate 51, and the mesa portions M including the light emitting elements 53 are formed on the laminated film 52 (A of Fig. 8). Specifically, with the front surface S1 of the substrate 51 facing upward, the laminated film 52 and the mesa portions M are formed on the upper surface (front surface S1) of the substrate 51, and then the front surface S1 of the substrate 51 faces downward. In this way, as illustrated in A of Fig. 8, the laminated film 52 and the mesa portions M are formed on the lower surface (front surface S1) of the substrate 51. In the process of A of Fig. 8, the anode electrodes 54 and the cathode electrodes 55 are further formed on the front surface S1 of the substrate 51.

Next, the lenses 71 and the protrusion 72 are formed on the back surface S2 (upper surface) of the substrate 51 by lithography and dry etching (B of Fig. 8). The lenses 71 and the protrusion 72 of the present embodiment are formed as part of the substrate 51 on the back surface S2 of the substrate 51. Note that the lenses 71 and the protrusion 72 are simultaneously formed by the same etching in the present embodiment, but may be formed in order by different etching. Next, the antireflection film 73 is formed on the back surface S2 of the substrate 51 so as to cover the lenses 71 and the protrusion 72 (B of Fig. 8).

As described above, the lenses 71 and the protrusion 72 of the present embodiment are formed such that the height of the uppermost portion of each lens 71 is equal to or less than the height of the uppermost portion of the protrusion 72 (see A of Fig. 4). As a result, as described above, the antireflection film 73 of the present embodiment is formed such that the height of the uppermost portion of the first portion X1 on each lens 71 is equal to or less than the height of the uppermost portion of the second portion X2 on the protrusion 72 (see A of Fig. 4). In B of Fig. 8, since the height of the uppermost portion of each lens 71 is lower than the height of the uppermost portion of the protrusion 72, the height of the uppermost portion of the first portion X1 on each lens 71 is lower than the height of the uppermost portion of the second portion X2 on the protrusion 72.

Next, the substrate 51 is cut in the above-described scribe region 82 (C of Fig. 8). As a result, the substrate 51 is divided into the above-described plurality of chip regions 81 as illustrated in D of Fig. 8.

Next, the substrate 51 (chip) is held by a collet 83, and the substrate 51 held by the collet 83 is mounted on the substrate 61 (D of Fig. 8). Specifically, the mesa portions M provided on the substrate 51 are arranged on the substrate 61 with the anode electrodes 54 or the cathode electrodes 55 (not illustrated), the bumps 48, and the connection pads 62 (not illustrated) interposed therebetween. As a result, the substrate 51 is electrically connected to the substrate 61. In this way, the light emitting device 1 of the present embodiment is manufactured.

In the present embodiment, the height of the uppermost portion of the antireflection film 73 (first portion X1) on the lenses 71 is lower than the height of the uppermost portion of the antireflection film 73 (second portion X2) on the protrusion 72. Therefore, the collet 83 can absorb the substrate 51 so as to be in contact with the antireflection film 73 on the protrusion 72 and not to be in contact with the antireflection film 73 on the lenses 71. As a result, it is possible to prevent the lenses 71 from being damaged by the pressure applied from the collet 83 to the lenses 71 and to prevent the substrate 51 from being hardly adsorbed by the collet 83 due to the lenses 71.

In the present embodiment, the height of the uppermost portion of the antireflection film 73 (first portion X1) on the lenses 71 may be the same as the height of the uppermost portion of the antireflection film 73 (second portion X2) on the protrusion 72. In this case, the collet 83 may contact not only the antireflection film 73 on the protrusion 72 but also the antireflection film 73 on the lenses 71. However, if the heights of the uppermost portions are the same, it is possible to suppress application of a large pressure from the collet 83 to the lenses 71, and the substrate 51 can be suitably adsorbed above the protrusion 72. Therefore, the height of the uppermost portion of the antireflection film 73 on the lenses 71 may be lower than the height of the uppermost portion of the antireflection film 73 on the protrusion 72, or may be the same as the height of the uppermost portion of the antireflection film 73 on the protrusion 72.

Furthermore, according to the present embodiment, by forming the antireflection film 73 on the protrusion 72, it is possible to make the antireflection film 73 less likely to be peeled off from the substrate 51. The reason is that the antireflection film 73 is hardly peeled off from the end surface of the substrate 51 as the antireflection film 73 is caught by the protrusion 72. The effect that the antireflection film 73 is hardly peeled off can be obtained during and after manufacturing of the light emitting device 1.

The area of the substrate 51 of the present embodiment after dicing is small, and the area of each lens 71 of the present embodiment is also small. Therefore, the lenses 71 of the present embodiment are easily damaged by the pressure from the collet 83. Furthermore, since the substrate 51 of the present embodiment is a GaAs substrate, this also causes the lenses 71 to be easily damaged. According to the present embodiment, it is possible to prevent the lenses 71, which are sensitive structure, from being damaged.

The substrate 51 of the present embodiment is mounted on the substrate 61 after dicing. At this time, according to the present embodiment, it is possible to suppress damage to the lenses 71 due to application of pressure from the collet 83 to the lenses 71 and difficulty in absorbing the substrate 51 by the collet 83 due to the lenses 71. Therefore, according to the present embodiment, it is possible to form a circuit for the light emitting device 1 on an inexpensive Si substrate (substrate 51) while forming the light emitting elements 53 and the lenses 71 on a high-performance GaAs substrate (substrate 61).

As described above, in the light emitting device 1 of the present embodiment, the height of the uppermost portion of the antireflection film 73 (first portion X1) on each lens 71 is equal to or less than the height of the uppermost portion of the antireflection film 73 (second portion X2) on the protrusion 72. Therefore, according to the present embodiment, the lenses 71 can be provided on the substrate 51 in a suitable manner. For example, when the substrate 51 is adsorbed and mounted on the substrate 61, by holding the substrate 51 by adsorption in the second portion X2, it is possible to suppress damage to the lenses 71 due to application of pressure to the lenses 71 and to suppress difficulty in adsorption of the substrate 51 due to the lenses 71.

Note that the lenses 71 and the protrusion 72 of the present embodiment are covered with a film on the substrate 51, specifically, covered with the antireflection film 73 on the substrate 51. However, the lenses 71 and the protrusion 72 may be constituted by a film on the substrate 51. This film may be the antireflection film 73 or a film different from the antireflection film 73. Details of such a film will be described later.

### (Second to Ninth Embodiments)

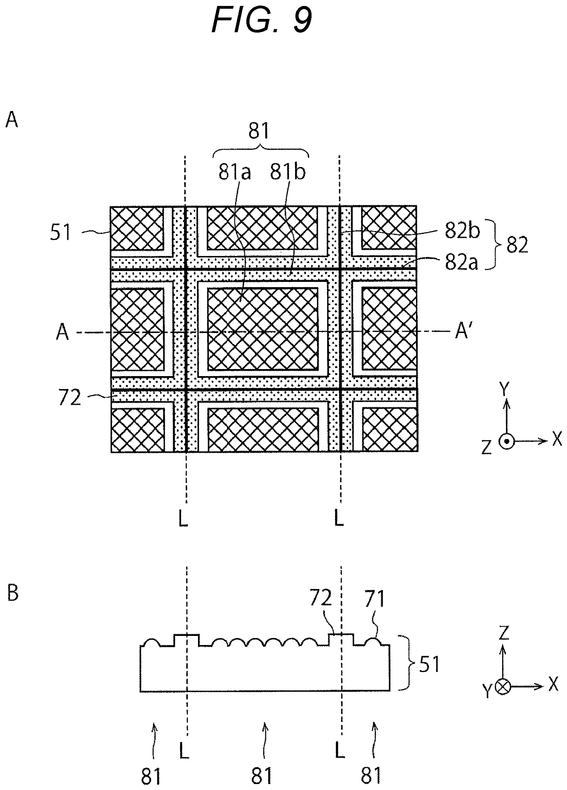

Fig. 9 is a plan view and a cross-sectional view illustrating a structure of a substrate 51 of a light emitting device 1 of a second embodiment. The relationship between A and B in Fig. 9 is similar to the relationship between A and B in Fig. 6.

As illustrated in A and B of Fig. 9, the protrusion 72 of the present embodiment is continuously formed in the chip region 81 and the scribe region 82 of the substrate 51. Specifically, the protrusion 72 of the present embodiment includes a portion formed in each peripheral region 81b and a portion formed in the scribe lines 82a and 82b, and annularly surrounds each lens region 81a. When the substrate 51 of the present embodiment is diced, one protrusion 72 is divided into protrusions 72 in the individual chip regions 81. Since the width of the protrusion 72 of the present embodiment is wider than the width of the protrusion 72 of the first embodiment, the protrusion 72 of the present embodiment can be generally formed more easily than the protrusion 72 of the first embodiment.

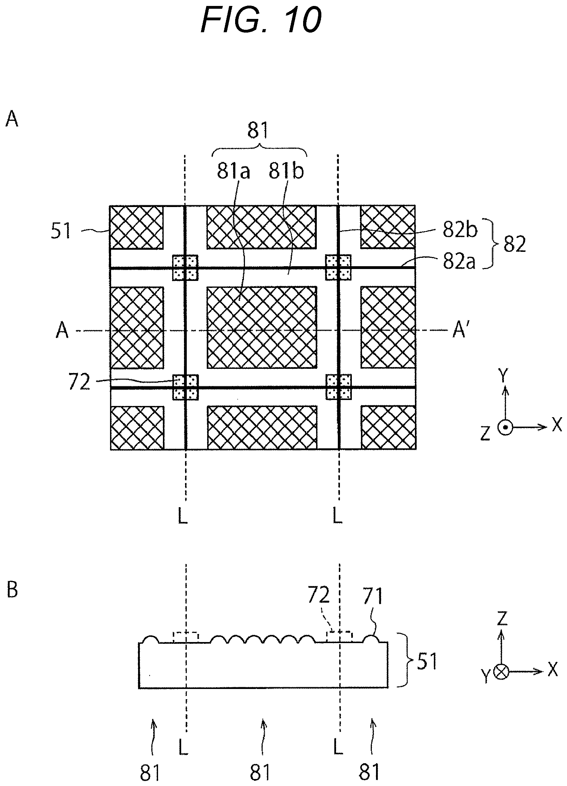

Fig. 10 is a plan view and a cross-sectional view illustrating a structure of a substrate 51 of a light emitting device 1 of a third embodiment. The relationship between A and B in Fig. 10 is similar to the relationship between A and B in Fig. 6.

Each protrusion 72 of the present embodiment is arranged at each intersection of the scribe line 82a and the scribe line 82b or in the vicinity thereof. Specifically, each protrusion 72 of the present embodiment includes a portion formed in four peripheral regions 81b adjacent to each other and a portion formed in the scribe region 82, and has a square (or rectangular) planar shape. When the substrate 51 of the present embodiment is diced, each chip region 81 includes four protrusions 72 provided at four corners of the back surface S2 of the substrate 51. Since the diced substrate 51 of the present embodiment includes the four protrusions 72 at the four corners, the collet 83 comes into contact with the four locations of the antireflection film 73, and the substrate 51 can be easily adsorbed by the collet 83.

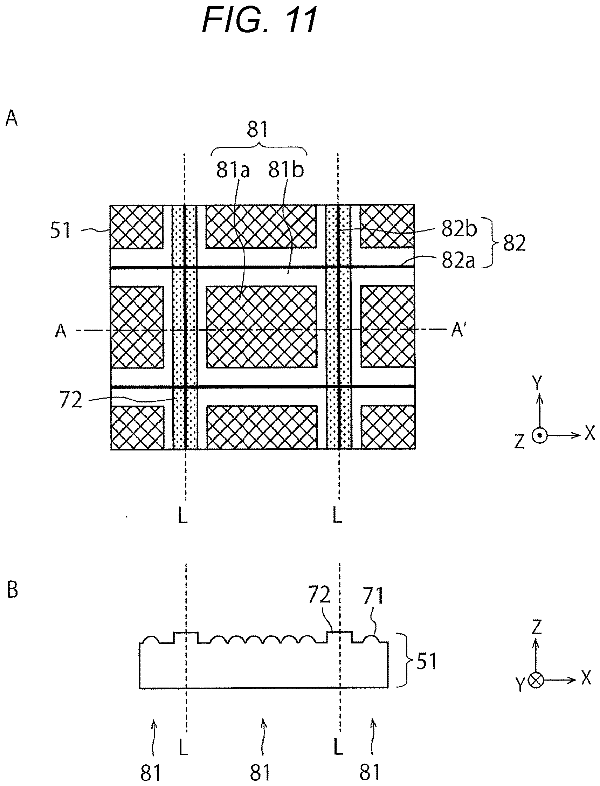

Fig. 11 is a plan view and a cross-sectional view illustrating a structure of a substrate 51 of a light emitting device 1 of a fourth embodiment. The relationship between A and B in Fig. 11 is similar to the relationship between A and B in Fig. 6.

Each protrusion 72 of the present embodiment is disposed in or near one scribe line 82b. Specifically, each protrusion 72 of the present embodiment includes a portion formed in the peripheral region 81b and a portion formed in the scribe region 82, and has a linear planar shape extending in the Y direction. When the substrate 51 of the present embodiment is diced, each chip region 81 includes a protrusion 72 extending linearly along one side of the back surface S2 of the substrate 51 and a protrusion 72 extending linearly along another side of the back surface S2 of the substrate 51. Similarly to the diced substrate 51 of the third embodiment, the diced substrate 51 of the present embodiment can also be easily adsorbed by the collet 83.

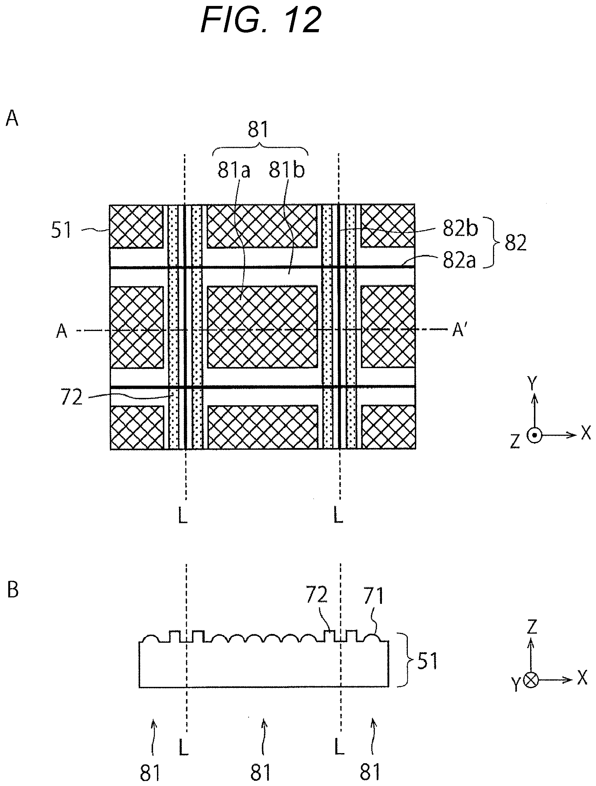

Fig. 12 is a plan view and a cross-sectional view illustrating a structure of a substrate 51 of a light emitting device 1 of a fifth embodiment. The relationship between A and B in Fig. 12 is similar to the relationship between A and B in Fig. 6.

Each protrusion 72 of the present embodiment is arranged in the +X direction or the -X direction of one scribe line 82b. Specifically, each protrusion 72 of the present embodiment includes a portion formed in the peripheral region 81b and a portion formed in the scribe line 82a, and has a linear planar shape extending in the Y direction. When the substrate 51 of the present embodiment is diced, each chip region 81 includes a protrusion 72 extending linearly along one side of the back surface S2 of the substrate 51 and a protrusion 72 extending linearly along another side of the back surface S2 of the substrate 51. Similarly to the diced substrates 51 of the third and fourth embodiments, the diced substrate 51 of the present embodiment can also be easily adsorbed by the collet 83.

Note that each of the protrusions 72 of the fourth and fifth embodiments may extend linearly in the X direction instead of the Y direction.

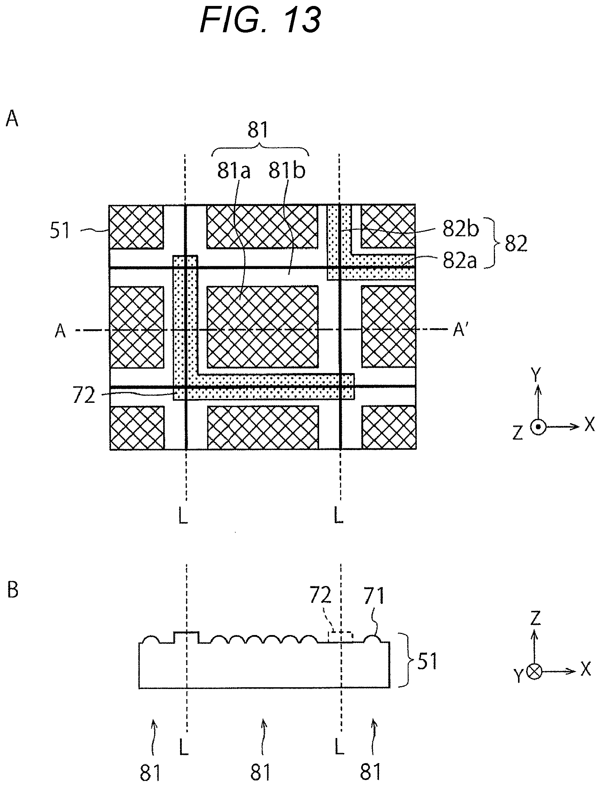

Fig. 13 is a plan view and a cross-sectional view illustrating a structure of a substrate 51 of a light emitting device 1 of a sixth embodiment. The relationship between A and B in Fig. 13 is similar to the relationship between A and B in Fig. 6.

Each protrusion 72 of the present embodiment is arranged in or near one pair of scribe lines 82a and 82b. Specifically, each protrusion 72 of the present embodiment includes a portion formed in the peripheral region 81b and a portion formed in the scribe region 82, and has an L-shaped planar shape extending in the X direction and the Y direction. When the substrate 51 of the present embodiment is diced, each chip region 81 includes a protrusion 72 extending in an L shape along two sides of the back surface S2 of the substrate 51 and a protrusion 72 provided at one corner of the back surface S2 of the substrate 51 (depending on the chip region 81, one protrusion 72 extending linearly along one side and two protrusions 72 provided at two corners are included). Since the diced substrate 51 of the present embodiment is also adsorbed by these two protrusions 72, it can be easily adsorbed by the collet 83.

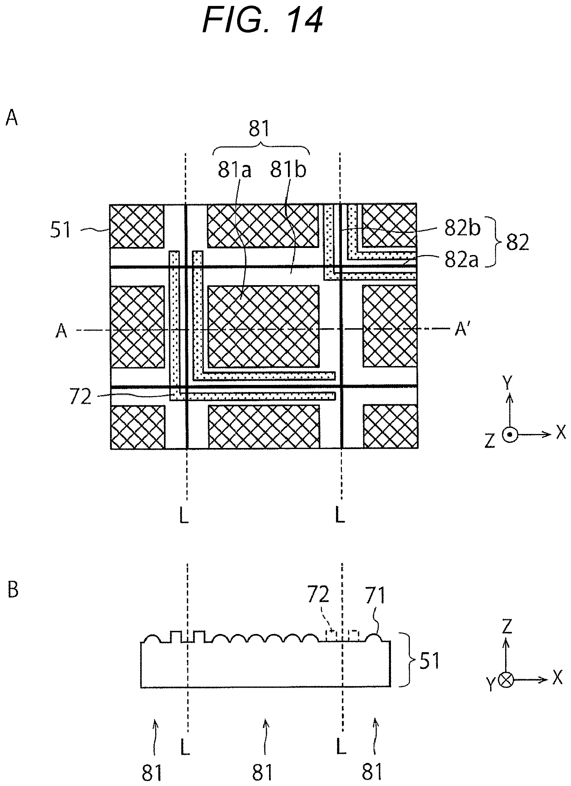

Fig. 14 is a plan view and a cross-sectional view illustrating a structure of a substrate 51 of a light emitting device 1 of a seventh embodiment. The relationship between A and B in Fig. 14 is similar to the relationship between A and B in Fig. 6.

Each protrusion 72 of the present embodiment is arranged in the +X and +Y directions or the -X and -Y directions of one pair of scribe lines 82a and 82b. Specifically, each protrusion 72 of the present embodiment includes a portion formed in the peripheral region 81b and a portion formed in the scribe lines 82a and 82b, and has an L-shaped planar shape extending in the X direction and the Y direction. When the substrate 51 of the present embodiment is diced, each chip region 81 includes a protrusion 72 extending in an L shape along two sides of the back surface S2 of the substrate 51 and a protrusion 72 provided near one corner of the back surface S2 of the substrate 51 (depending on the chip region 81, one protrusion 72 extending linearly along one side and two protrusions 72 provided at two corners are included). Since the diced substrate 51 of the present embodiment is also adsorbed by these two protrusions 72, it can be easily adsorbed by the collet 83.

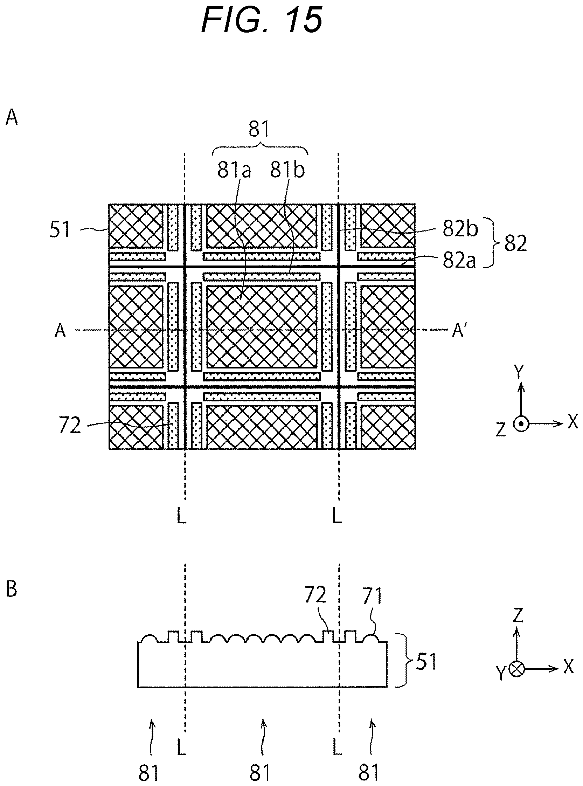

Fig. 15 is a plan view and a cross-sectional view illustrating a structure of a substrate 51 of a light emitting device 1 of an eighth embodiment. The relationship between A and B in Fig. 15 is similar to the relationship between A and B in Fig. 6.

Each protrusion 72 of the present embodiment is arranged in the +Y direction, the -Y direction, the +X direction, or the -X direction of one scribe line 82a or 82b. Specifically, each protrusion 72 of the present embodiment is formed in the peripheral region 81b and has a linear planar shape extending in the X direction or the Y direction. When the substrate 51 of the present embodiment is diced, each chip region 81 includes four protrusions 72 extending linearly along four sides of the back surface S2 of the substrate 51. Since the diced substrate 51 of the present embodiment is adsorbed by these four protrusions 72, it can be easily adsorbed by the collet 83.

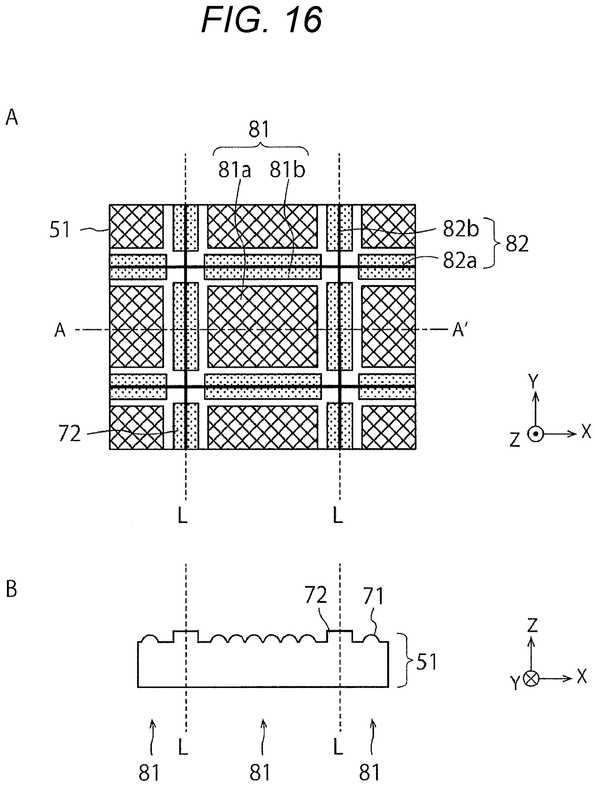

Fig. 16 is a plan view and a cross-sectional view illustrating a structure of a substrate 51 of a light emitting device 1 of a ninth embodiment. The relationship between A and B in Fig. 16 is similar to the relationship between A and B in Fig. 6.

Each protrusion 72 of the present embodiment is arranged in or near one scribe line 82a or 82b. Specifically, each protrusion 72 of the present embodiment includes a portion formed in the peripheral region 81b and a portion formed in the scribe line 82a or 82b, and has a linear planar shape extending in the X direction or the Y direction. When the substrate 51 of the present embodiment is diced, each chip region 81 includes four protrusions 72 extending linearly along four sides of the back surface S2 of the substrate 51. Since the diced substrate 51 of the present embodiment is adsorbed by these four protrusions 72, it can be easily adsorbed by the collet 83.

In these embodiments, similarly to the first embodiment, the height of the uppermost portion of the antireflection film 73 (first portion X1) on each lens 71 is set to be equal to or less than the height of the uppermost portion of the antireflection film 73 (second portion X2) on the protrusion 72. Therefore, according to these embodiments, the lenses 71 can be provided on the substrate 51 in a suitable manner.

The light emitting device 1 of these embodiments can be manufactured by the method illustrated in Fig. 8, similarly to the light emitting device 1 of the first embodiment. However, in the process illustrated in B of Fig. 8, the protrusion 72 is formed so as to have the shape of the protrusion 72 of each of the second to ninth embodiments.

### (10th Embodiment)

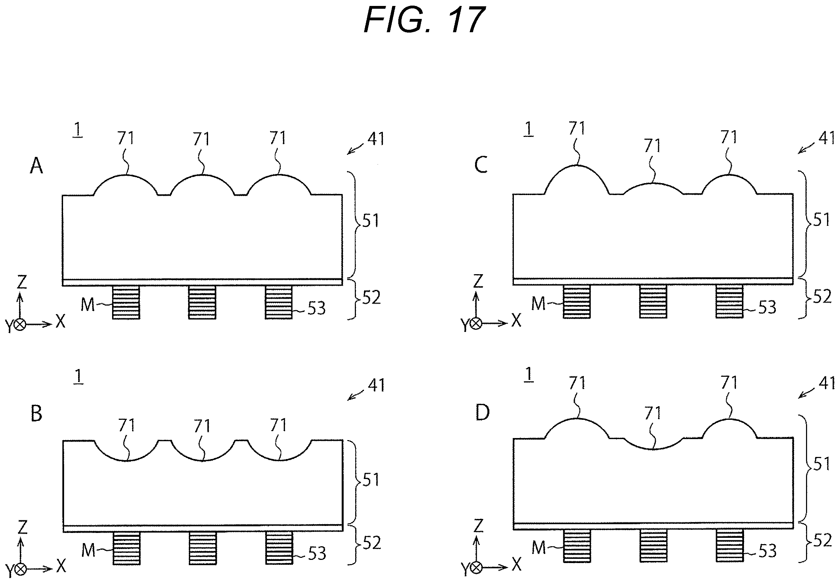

A light emitting device 1 of a 10th embodiment corresponds to a light emitting device 1 of a modification of the first to ninth embodiments. Hereinafter, various examples of the light emitting device 1 of the 10th embodiment will be described with reference to Figs. 17 to 20.

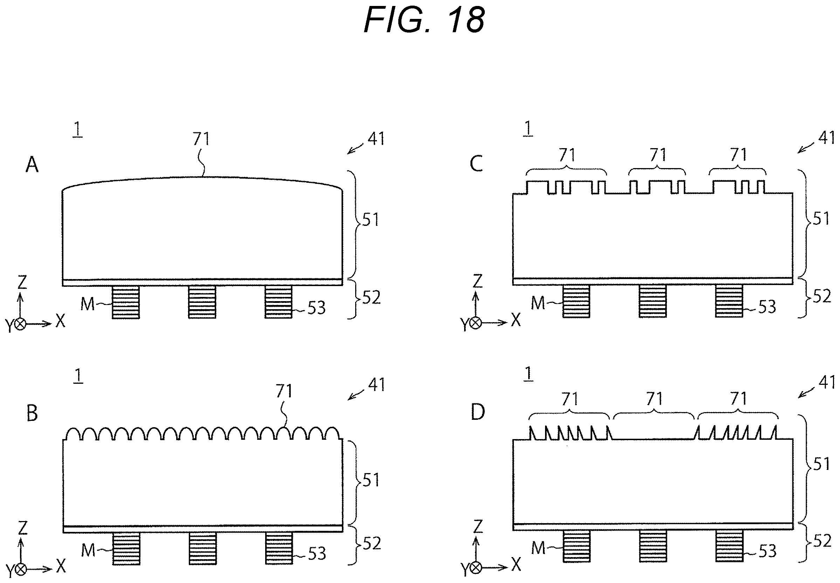

Figs. 17 and 18 are cross-sectional views illustrating examples of a structure of a substrate 51 of the light emitting device 1 of the 10th embodiment. Each of A of Fig. 17 to D of Fig. 18 illustrates a cross section of the substrate 51 and the like of the light emitting device 1 similarly to A of Fig. 4, but illustration of the protrusion 72, the antireflection film 73, and the like is omitted.

Similarly to the substrate 51 in A of Fig. 4, the substrate 51 in A of Fig. 17 includes a plurality of lenses 71 which is convex lenses corresponding to the light emitting elements 53 on a one-to-one basis. Similarly, each substrate 51 of B, C, and D of Fig. 17 includes a plurality of lenses 71 corresponding to the light emitting elements 53 on a one-to-one basis. However, the substrate 51 in B of Fig. 17 includes concave lenses, the substrate 51 in C of Fig. 17 includes convex lenses having different shapes (curvatures), and the substrate 51 in D of Fig. 17 includes both convex lenses and concave lenses. As described above, each lens 71 of the present embodiment may be a convex lens or a concave lens.

In the substrate 51 in A of Fig. 18, the light emitting elements 53 and the lenses 71 correspond to each other at N : 1 (N is an integer of 2 or more). Therefore, in A of Fig. 18, light emitted from N light emitting elements 53 is incident on one lens 71. Meanwhile, in the substrate 51 in B of Fig. 18, the light emitting elements 53 and the lenses 71 correspond to each other at 1 : N. Therefore, in B of Fig. 18, light emitted from one light emitting element 53 is incident on N lenses 71. As described above, each lens 71 of the present embodiment may not correspond to the light emitting element 53 at 1 : 1.

In the substrate 51 in C of Fig. 18, the light emitting elements 53 and the lenses 71 correspond to each other at 1 : 1. However, the substrate 51 in C of Fig. 18 includes Fresnel lenses. Similarly, in the substrate 51 in D of Fig. 18, the light emitting elements 53 and the lenses 71 correspond at 1 : 1. However, the substrate 51 in D of Fig. 18 includes binary lenses and flat lenses. As described above, each lens 71 of the present embodiment may be a lens other than a convex lens or a concave lens.

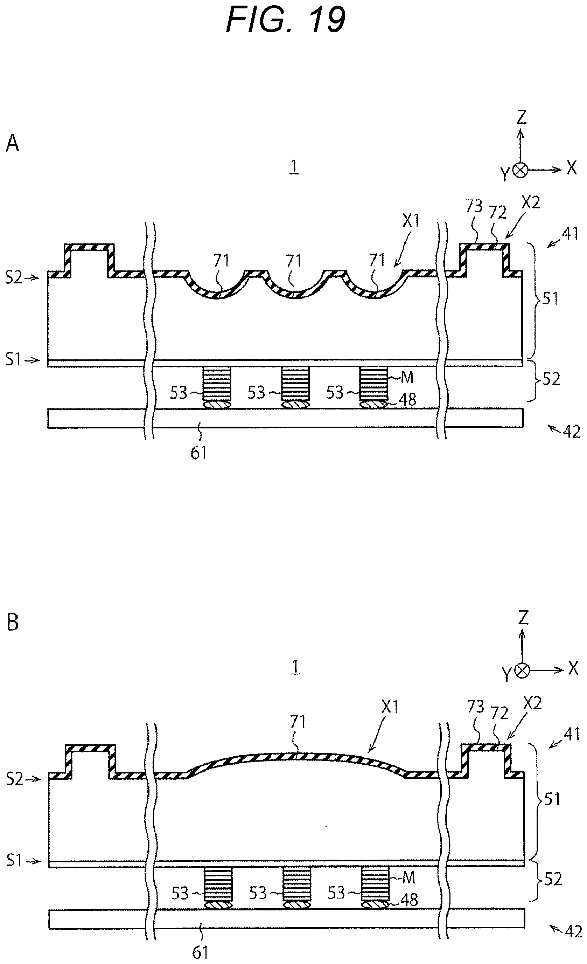

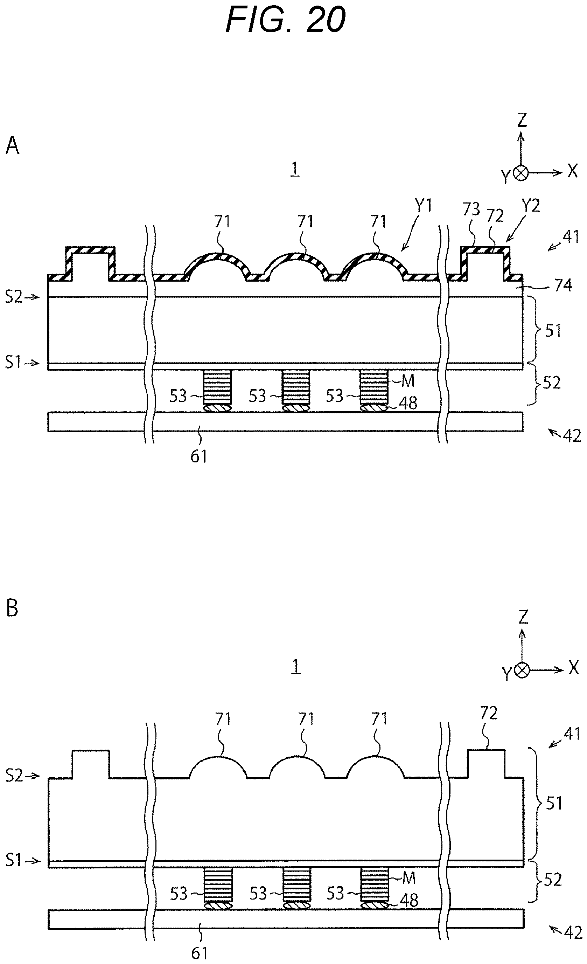

Figs. 19 and 20 are cross-sectional views illustrating an example of a structure of the light emitting device 1 of the 10th embodiment. Each of A of Fig. 19 to B of Fig. 20 illustrates a cross section of the substrate 51 and the like of the light emitting device 1 similarly to A of Fig. 4.

In the substrate 51 in A of Fig. 19, similarly to the substrate 51 in A of Fig. 4, the light emitting elements 53 and the lenses 71 correspond to each other at 1 : 1. However, the substrate 51 in A of Fig. 19 includes not convex lenses but concave lenses. A of Fig. 19 further illustrates the protrusion 72 provided on the back surface S2 of the substrate 51 and the antireflection film 73 formed on the back surface S2 of the substrate 51 so as to cover the lenses 71 and the protrusion 72. In A of Fig. 19, similarly to A of Fig. 4, the height of the uppermost portion of the antireflection film 73 (first portion X1) on each lens 71 is equal to or less than the height of the uppermost portion of the antireflection film 73 (second portion X2) on the protrusion 72. Note that the uppermost portion of each lens 71 in A of Fig. 19 is an edge portion of the lens 71.

The lenses 71 in A of Fig. 19 are concave lenses. Also in this case, unevenness caused by the lenses 71 are generated on the upper surface of the antireflection film 73 on the lenses 71. Therefore, when the substrate 51 is to be adsorbed by the antireflection film 73 on the lenses 71, pressure may be applied to the lenses 71 to damage the lenses 71, or the substrate 51 may be difficult to be adsorbed due to the lenses 71. However, since the substrate 51 in A of Fig. 19 can be adsorbed by the antireflection film 73 on the protrusion 72, these problems can be suppressed.

The substrate 51 in B of Fig. 19 includes convex lenses as the lenses 71, similarly to the substrate 51 in A of Fig. 4. However, in the substrate 51 in B of Fig. 19, the light emitting elements 53 and the lenses 71 correspond to each other at N : 1. A of Fig. 19 further illustrates the protrusion 72 provided on the back surface S2 of the substrate 51 and the antireflection film 73 formed on the back surface S2 of the substrate 51 so as to cover the lenses 71 and the protrusion 72. In B of Fig. 19, similarly to A of Fig. 4, the height of the uppermost portion of the antireflection film 73 (first portion X1) on each lens 71 is equal to or less than the height of the uppermost portion of the antireflection film 73 (second portion X2) on the protrusion 72. Since the substrate 51 in B of Fig. 19 can also be adsorbed by the antireflection film 73 on the protrusion 72, the problem described above can be suppressed.

The light emitting device 1 in A of Fig. 20 includes a semiconductor film 74 in addition to the lenses 71, the protrusion 72, the antireflection film 73, and the like. In A of Fig. 20, the semiconductor film 74 is formed on the back surface S2 of the substrate 51. Furthermore, the lenses 71 and the protrusion 72 are provided as part of the semiconductor film 74 on the upper surface of the semiconductor film 74. Furthermore, the antireflection film 73 is formed on the upper surface of the semiconductor film 74 so as to cover the lenses 71 and the protrusion 72. The antireflection film 73 and the semiconductor film 74 in A of Fig. 20 are examples of the first film of the present disclosure. Specifically, the antireflection film 73 is a film disposed on the lenses 71 and the protrusion 72, and the semiconductor film 74 is a film forming the lenses 71 and the protrusion 72. The semiconductor film 74 is, for example, a silicon (Si) film.

The antireflection film 73 and the semiconductor film 74 in A of Fig. 20 include a first portion Y1 disposed on the lenses 71 or forming the lenses 71 and a second portion Y2 disposed on the protrusion 72 or forming the protrusion 72. Then, the height of the uppermost portion of each lens 71 is equal to or less than the height of the uppermost portion of the protrusion 72. As a result, the height of the uppermost portion of the first portion Y1 of the antireflection film 73 and the semiconductor film 74 is equal to or less than the height of the uppermost portion of the second portion Y2 of the antireflection film 73 and the semiconductor film 74. As a result, when the substrate 51 is adsorbed and mounted on the substrate 61, it is possible to suppress damage to the lenses 71 due to application of pressure to the lenses 71 and difficulty in adsorption of the substrate 51 due to the lenses 71.

Note that the antireflection film 73 illustrated in A of Fig. 20 may be understood as a film forming the protrusion 72 instead of being understood as a film arranged on the protrusion 72. In both the former case and the latter case, the height of the uppermost portion of the first portion Y1 of the antireflection film 73 and the semiconductor film 74 is set to be equal to or less than the height of the uppermost portion of the second portion Y2 of the antireflection film 73 and the semiconductor film 74. It similarly applies to the antireflection film 73 of the first to ninth embodiments and the antireflection film 73 of other examples of the 10th embodiment.

The light emitting device 1 in B of Fig. 20 includes the lenses 71, the protrusion 72, and the like similarly to the light emitting device 1 in A of Fig. 4, but does not include the antireflection film 73. As described above, the light emitting device 1 of the present embodiment may not include the antireflection film 72. In this case, the collet 83 contacts not the upper surface of the antireflection film 73 but the back surface S2 of the substrate 51.

In B of Fig. 20, the height of the uppermost portion of each lens 71 is equal to or less than the height of the uppermost portion of the protrusion 72. Therefore, the substrate 51 can be held by being adsorbed by the protrusion 72. As a result, when the substrate 51 is adsorbed and mounted on the substrate 61, it is possible to suppress damage to the lenses 71 due to application of pressure to the lenses 71 and difficulty in adsorption of the substrate 51 due to the lenses 71.

The light emitting devices 1 of the examples of A of Fig. 17 to B of Fig. 20 can be manufactured by the method illustrated in Fig. 8, similarly to the light emitting device 1 of the first embodiment. However, in the process illustrated in B of Fig. 8, the lenses 71 and the protrusion 72 are formed so as to have the shapes of the lenses 71 and the protrusion 72 of each example. Furthermore, when the light emitting device 1 in A of Fig. 20 is manufactured, the process illustrated in B of Fig. 8 is performed on the semiconductor film 74 instead of the substrate 51 after the semiconductor film 74 is formed on the back surface S2 of the substrate 51. Furthermore, when the light emitting device 1 in B of Fig. 20 is manufactured, the formation of the antireflection film 73 is omitted in the process illustrated in B of Fig. 8.

### (11th Embodiment)

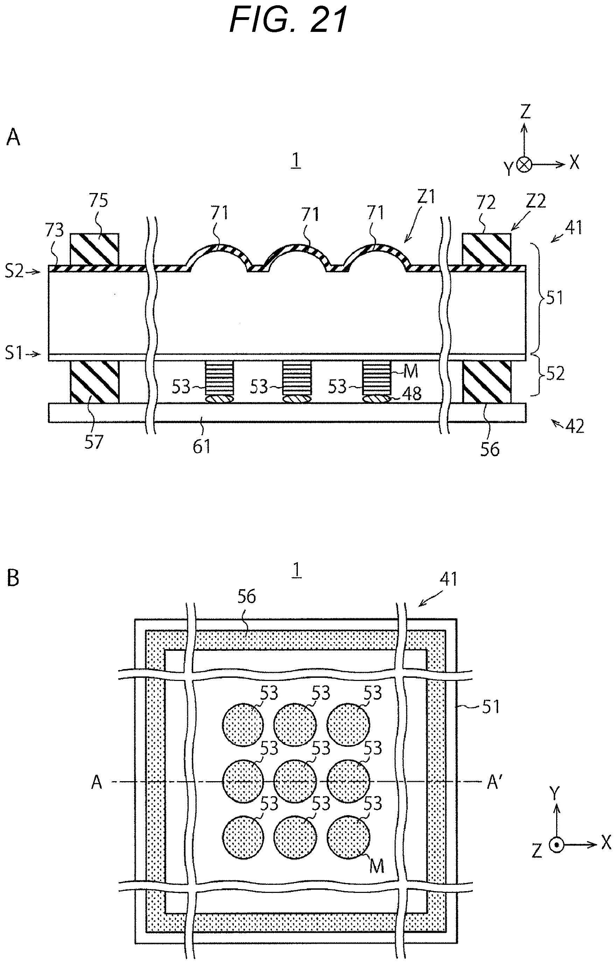

Fig. 21 is a plan view and a cross-sectional view illustrating a structure of a light emitting device 1 of an 11th embodiment.

A of Fig. 21 illustrates cross sections of the LD chip 41 and the LDD substrate 42 in the light emitting device 1, similarly to A of Fig. 4. The LD chip 41 of the present embodiment includes a protrusion 56, a protrusion forming film 57, and a protrusion forming film 75 in addition to the components illustrated in A of Fig. 4. The protrusion 56 is an example of a second protrusion of the present disclosure. The protrusion forming film 57 is an example of the second film of the present disclosure. Meanwhile, the protrusion forming film 75 is an example of the first film of the present disclosure. Note that, in A of Fig. 21, similarly to A of Fig. 4, illustration of the anode electrodes 54, the cathode electrodes 55, and the connection pads 62 is omitted.

The protrusion 72 illustrated in A of Fig. 4 is formed by a part of the substrate 51, whereas the protrusion 72 of the present embodiment is formed by the protrusion forming film 75. The protrusion forming film 75 is formed on the back surface S2 of the substrate 51 via the antireflection film 73. The protrusion forming film 75 is, for example, a light absorbing film, an inorganic film, or an organic film. The protrusion 72 of the present embodiment has a shape that annularly surrounds all the lenses 71 on the substrate 51, similarly to the protrusion 72 illustrated in B of Fig. 4.

As described above, the LD chip 41 of the present embodiment includes the antireflection film 73 and the protrusion forming film 75 on the back surface S2 of the substrate 51. The antireflection film 73 and the protrusion forming film 75 of the present embodiment include a first portion Z1 disposed on the lens 71 and a second portion Z2 forming the protrusion 72. The first portion Z1 includes only the antireflection film 73 of the antireflection film 73 and the protrusion forming film 75. The second portion Z2 includes only the protrusion forming film 75 of the antireflection film 73 and the protrusion forming film 75.

The protrusion 56 is provided on the front surface S1 of the substrate 51 and has a protruding shape protruding from the substrate 51 in the -Z direction. The protrusion 56 of the present embodiment is formed by the protrusion forming film 57. The protrusion forming film 57 is formed below the front surface S1 of the substrate 51 with a part of the laminated film 52 interposed therebetween. The protrusion forming film 57 is, for example, a light absorbing film, an inorganic film, or an organic film. As described later, the protrusion 56 of the present embodiment has a shape annularly surrounding all the light emitting elements 53 under the substrate 51 (see B of Fig. 21).

Here, shapes of the lenses 51 and the light emitting elements 53 of the present embodiment will be described.

In the present embodiment, similarly to the first embodiment (A of Fig. 4), the height of the uppermost portion of each lens 71 is equal to or less than the height of the uppermost portion of the protrusion 72. In other words, the Z coordinate of the uppermost portion of each lens 71 is equal to or less than the Z coordinate of the uppermost portion of the protrusion 72. Since each lens 71 of the present embodiment is a convex lens, the uppermost portion of each lens 71 is the top portion of each lens 71. Meanwhile, since the protrusion 72 of the present embodiment has a flat upper surface, the uppermost portion of the protrusion 72 is the upper surface of the protrusion 72. Therefore, in the present embodiment, the height of the top portion of each lens 71 is equal to or less than the height of the upper surface of the protrusion 72. In addition, the height of the uppermost portion of the first portion Z1 on each lens 71 is equal to or less than the height of the uppermost portion of the second portion Z2 in the protrusion 72.

Furthermore, in the present embodiment, the height of the lowermost portion of each light emitting element 53 is equal to or higher than the height of the lowermost portion of the protrusion 56. In other words, the Z coordinate of the lowermost portion of each light emitting element 53 is equal to or larger than the Z coordinate of the lowermost portion of the protrusion 56. Since each light emitting element 53 of the present embodiment has a substantially flat lower surface, the lowermost portion of each light emitting element 53 is the lower surface of each light emitting element 53. Similarly, since the protrusion 56 of the present embodiment has a flat lower surface, the lowermost portion of the protrusion 56 is the lower surface of the protrusion 56. Therefore, in the present embodiment, the height of the lower surface of each light emitting element 53 is equal to or higher than the height of the lower surface of the protrusion 56.

When the light emitting device 1 of the present embodiment is manufactured, as described later, the substrate 51 is held by adsorbing the substrate 51, and the substrate 51 held by the adsorption is mounted on the substrate 61. At this time, when the substrate 51 is to be adsorbed at the position of the light emitting element 53, pressure may be applied to the light emitting elements 53 to damage the light emitting elements 53, or the substrate 51 may be difficult to adsorb due to the light emitting elements 53. However, since the height of the lowermost portion of the light emitting elements 53 of the present embodiment is equal to or higher than the height of the lowermost portion of the protrusion 56, the substrate 51 can be adsorbed at the position of the protrusion 56. As a result, it is possible to suppress damage to the light emitting elements 53 due to application of pressure to the light emitting elements 53 and difficulty in adsorption of the substrate 51 due to the light emitting elements 53.

Note that the plurality of light emitting elements 53 described above has the same shape in the present embodiment, but may have different shapes. Furthermore, the protrusion 56 has a flat lower surface in the present embodiment, but may have a non-flat lower surface. Furthermore, the LD chip 41 includes the protrusion 56 and the protrusion 72 in the present embodiment, but may include only the protrusion 56 of the protrusion 56 and the protrusion 72. Even in these cases, the effect described above can be obtained by setting the height of the lowermost portion of each light emitting element 53 to be equal to or higher than the height of the lowermost portion of the protrusion 56.

B of Fig. 21 illustrates a layout of the light emitting elements 53 and the protrusion 56 provided on the front surface S1 of the substrate 51. In B of Fig. 21, the light emitting elements 53 are arranged in a two-dimensional array on the front surface S1 of the substrate 51, specifically, arranged in a square lattice pattern. Furthermore, the protrusion 56 has a quadrangular annular shape extending along the four sides of the quadrangular front surface S1, and annularly surrounds all the light emitting elements 53 on the substrate 51. Note that A of Fig. 21 illustrates a cross section taken along line A-A' illustrated in B of Fig. 21.

In the present embodiment, the protrusion 56 has a planar shape illustrated in B of Fig. 21, and the protrusion 72 has a planar shape illustrated in B of Fig. 4. Therefore, the protrusion 56 and the protrusion 72 of the present embodiment have the same shape in plan view and are arranged at the same position in plan view. Therefore, the protrusion 56 and the protrusion 72 of the present embodiment are arranged so as to overlap each other in the Z direction. Note that the protrusion 56 and the protrusion 72 may have different shapes in plan view or may be arranged at different positions in plan view as described later.

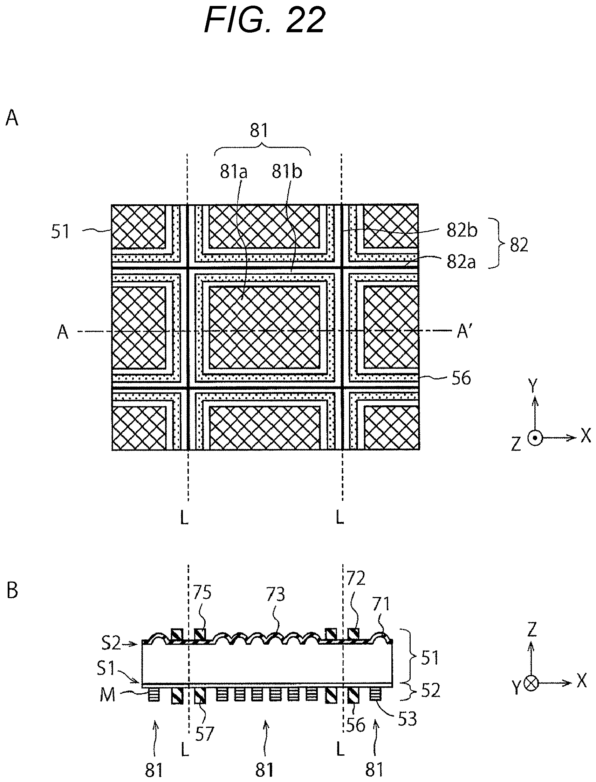

Fig. 22 is a plan view and a cross-sectional view illustrating a structure of a substrate 51 of a light emitting device 1 of an 11th embodiment. A of Fig. 22 is a plan view illustrating a structure of the substrate 51 before dicing, and B of Fig. 22 is a cross-sectional view taken along line A-A' illustrated in A of Fig. 22.

As illustrated in A and B of Fig. 22, the substrate 51 of the present embodiment includes a plurality of chip regions 81 and a scribe region 82. The structure of the chip regions 81 and the scribe region 82 of the present embodiment are substantially the same as the structure of the chip regions 81 and the scribe region 82 of the first embodiment (see A and B of Fig. 6).

However, the substrate 51 of the present embodiment is provided with a plurality of protrusions 56. These protrusions 56 are provided in the chip regions 81 of the substrate 51, and specifically, one protrusion 56 is provided in one chip region 81 (A of Fig. 22). Each protrusion 56 is provided in the peripheral region 81b and has a planar shape annularly surrounding the lens region 81a. It should be noted that each protrusion 56 of the present embodiment is not provided in the scribe region 82 as illustrated in A and B of Fig. 22.

As illustrated in B of Fig. 22, the substrate 51 of the present embodiment includes the plurality of protrusions 56 on the front surface S1 of the substrate 51 and the plurality of protrusions 72 on the back surface S2 of the substrate 51. The protrusion 56 and the protrusion 72 of the present embodiment have the same shape in plan view and are arranged at the same position in plan view. Therefore, the protrusion 56 and the protrusion 72 of the present embodiment are arranged so as to overlap each other in the Z direction. A of Fig. 22 illustrates the protrusion 56, but illustration of the protrusion 72 is omitted. For the planar shape of the protrusion 72 of the present embodiment, refer to A of Fig. 6.

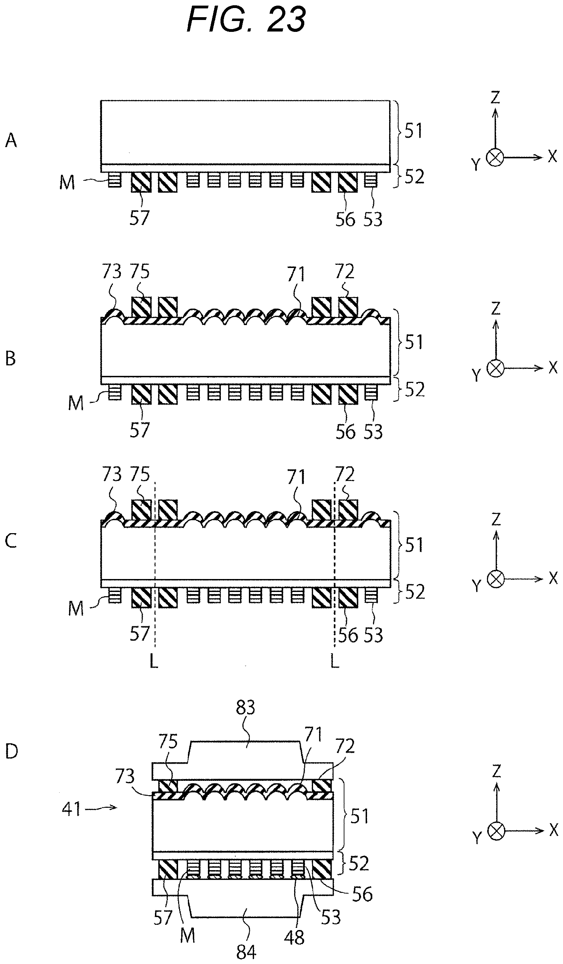

Fig. 23 is a cross-sectional view illustrating the method for manufacturing the light emitting device 1 of the 11th embodiment.

First, the laminated film 52 is formed on the front surface S1 of the substrate 51, the mesa portions M including the light emitting elements 53 are formed on the laminated film 52, and the protrusions 56 are formed on the front surface S1 of the substrate 51 with part of the laminated film 52 interposed therebetween (A of Fig. 23). Specifically, with the front surface S1 of the substrate 51 facing upward, the laminated film 52, the mesa portions M, and the protrusions 56 are formed on the upper surface (front surface S1) of the substrate 51, and then the front surface S1 of the substrate 51 faces downward. In this way, as illustrated in A of Fig. 23, the laminated film 52, the mesa portions M, and the protrusions 56 are formed on the lower surface (front surface S1) of the substrate 51. In the process of A of Fig. 23, the anode electrodes 54 and the cathode electrodes 55 are further formed on the front surface S1 of the substrate 51. The anode electrodes 54 and the cathode electrodes 55 may be formed before the formation of the protrusions 56, or may be formed after the formation of the protrusions 56.

Next, the lenses 71 are formed on the back surface S2 (upper surface) of the substrate 51 by lithography and dry etching (B of Fig. 23). The lenses 71 of the present embodiment are formed as part of the substrate 51 on the back surface S2 of the substrate 51. Next, the antireflection film 73 is formed on the back surface S2 of the substrate 51 so as to cover the lenses 71, and the protrusions 72 are formed on the back surface S2 of the substrate 51 with the antireflection film 73 interposed therebetween (B of Fig. 23).

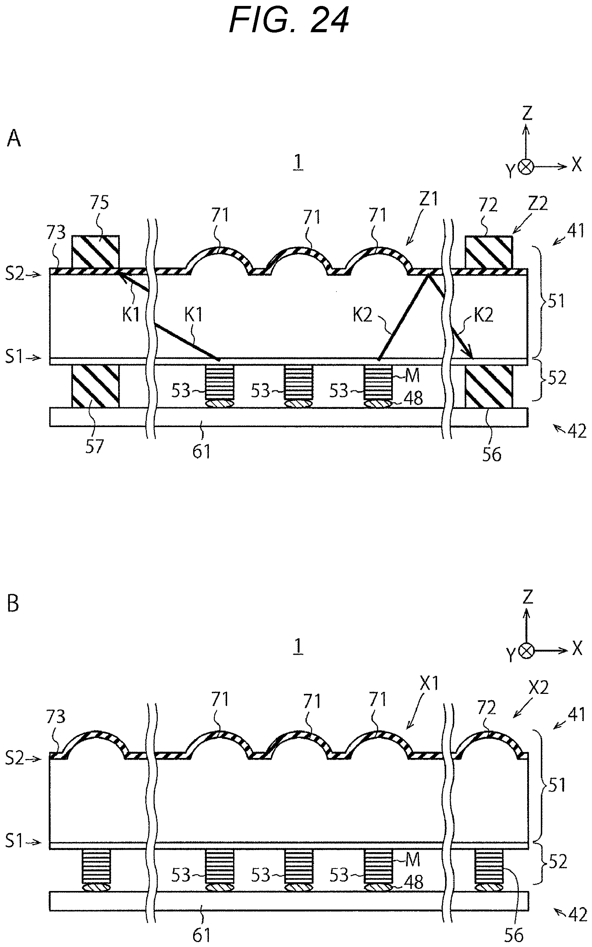

Next, the substrate 51 is cut in the above-described scribe region 82 (C of Fig. 23). As a result, the substrate 51 is divided into the above-described plurality of chip regions 81 as illustrated in D of Fig. 24.

Next, the substrate 51 (chip) is held by a collet 83 and a collet 84, and the substrate 51 held by the collet 83 and the collet 84 is mounted on the substrate 61 (D of Fig. 23). Specifically, the mesa portions M provided on the substrate 51 are arranged on the substrate 61 with the anode electrodes 54 or the cathode electrodes 55 (not illustrated), the bumps 48, and the connection pads 62 (not illustrated) interposed therebetween. As a result, the substrate 51 is electrically connected to the substrate 61. In this way, the light emitting device 1 of the present embodiment is manufactured. The collet 84 is an example of a second substrate holding device of the present disclosure.

The lenses 71 and the protrusion 72 of the present embodiment are formed such that the height of the uppermost portion of the antireflection film 73 (first portion Z1) on the lenses 71 is lower than the height of the uppermost portion of the protrusion forming film 75 (second portion Z2) in the protrusion 72. Therefore, the collet 83 can absorb the substrate 51 so as to be in contact with the protrusion forming film 75 in the protrusion 72 and not to be in contact with the antireflection film 73 on the lenses 71. As a result, it is possible to prevent the lenses 71 from being damaged by the pressure applied from the collet 83 to the lenses 71 and to prevent the substrate 51 from being hardly adsorbed by the collet 83 due to the lenses 71.

In the present embodiment, the height of the uppermost portion of the antireflection film 73 (first portion Z1) on the lenses 71 may be the same as the height of the uppermost portion of the protrusion forming film 75 (second portion Z2) in the protrusion 72. In this case, the collet 83 may contact not only the protrusion forming film 75 in the protrusion 72 but also the antireflection film 73 on the lenses 71. However, if the heights of the uppermost portions are the same, it is possible to suppress application of a large pressure from the collet 83 to the lenses 71, and the substrate 51 can be suitably adsorbed above the protrusion 72. Therefore, the height of the uppermost portion of the antireflection film 73 on the lenses 71 may be lower than the height of the uppermost portion of the protrusion forming film 75 in the protrusion 72, or may be the same as the height of the uppermost portion of the protrusion forming film 75 in the protrusion 72.

Furthermore, the light emitting elements 53 and the protrusion 56 of the present embodiment are formed such that the height of the lowermost portion of the light emitting elements 53 is higher than the height of the lowermost portion of the protrusion 56. Therefore, the collet 84 can absorb the substrate 51 so as to be in contact with the protrusion 56 and not to be in contact with the light emitting elements 53. As a result, it is possible to prevent the light emitting elements 53 from being damaged by the pressure applied from the collet 84 to the light emitting elements 53 and to prevent the substrate 51 from being hardly adsorbed by the collet 84 due to the light emitting elements 53.

In the present embodiment, the height of the lowermost portion of the light emitting elements 53 may be the same as the height of the lowermost portion of the protrusion 56. In this case, the collet 84 may contact not only the protrusion 56 but also the light emitting elements 53. However, if the heights of the lowermost portions are the same, it is possible to suppress application of a large pressure from the collet 84 to the light emitting elements 53, and the substrate 51 can be suitably adsorbed below the protrusion 56. Therefore, the height of the lowermost portion of the light emitting elements 53 may be lower than the height of the lowermost portion of the protrusion 56 or may be the same as the height of the lowermost portion of the protrusion 56.

The area of the substrate 51 of the present embodiment after dicing is small, and the areas of the lenses 71 and the light emitting elements 53 of the present embodiment are also small. Therefore, the lenses 71 and the light emitting elements 53 of the present embodiment are easily damaged by the pressure from the collets 83 and 84. Furthermore, since the substrate 51 of the present embodiment is a GaAs substrate, this also causes the lenses 71 to be easily damaged. According to the present embodiment, it is possible to suppress damage to the lenses 71 and the light emitting elements 53 which are sensitive structures.

As described with reference to A of Fig. 23, the anode electrodes 54 and the cathode electrodes 55 may be formed before the formation of the protrusion 56, or may be formed after the formation of the protrusion 56. In a case where the anode electrodes 54 and the cathode electrodes 55 are formed after the formation of the protrusion 56, the electrode material for the anode electrodes 54 and the cathode electrodes 55 is formed on the lower surface of the light emitting elements 53 but is not formed on the lower surface of the protrusion forming film 57 in D of Fig. 23. In this case, in order to prevent the collet 84 from applying a large pressure to each light emitting element 53, the height of the lowermost portion of the electrode material under the light emitting elements 53 is desirably equal to or higher than the height of the lowermost portion of the protrusion 56. Meanwhile, in a case where the electrode material is formed on both the lower surface of the light emitting elements 53 and the lower surface of the protrusion forming film 57, if the height of the lowermost portion of the light emitting elements 53 is equal to or higher than the height of the lowermost portion of the protrusion forming film 57, the height of the lowermost portion of the electrode material under the light emitting elements 53 is equal to or higher than the height of the lowermost portion of the electrode material under the protrusion forming film 57.

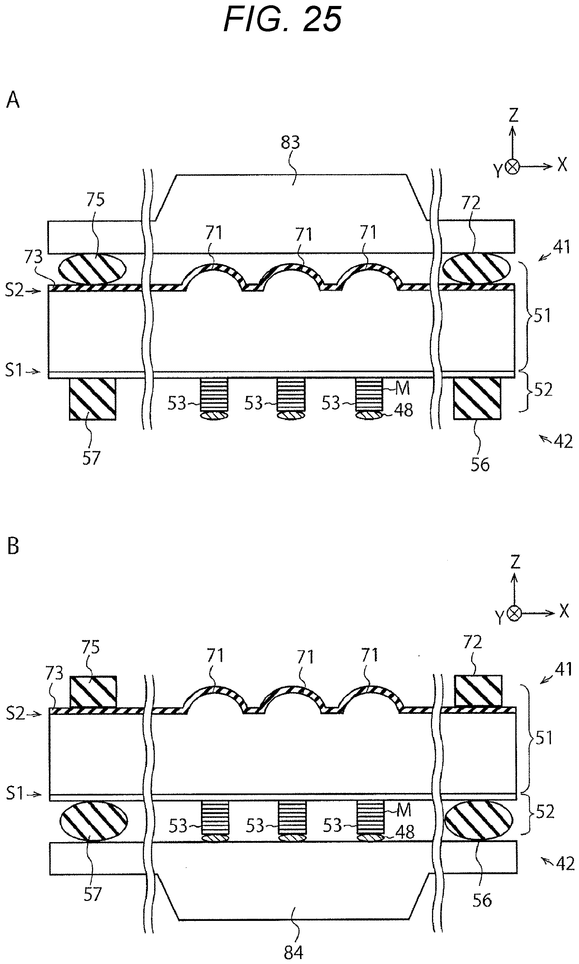

Figs. 24 and 25 are cross-sectional views illustrating a structure of a light emitting device 1 according to a modification of the 11th embodiment.

In the modification illustrated in A of Fig. 24, each of the protrusion forming films 75 and 57 is a light absorbing film having a function of absorbing light. An example of such a light absorbing film is an organic film. A of Fig. 24 illustrates a state in which the light emitted from the light emitting elements 53 is absorbed by the protrusion forming film 75 and the protrusion forming film 57. As a result, it is possible to prevent stray light from the light emitting elements 53 from being reflected by the protrusion 72 or the protrusion 56. Note that in a case where the light emitting elements 53 emit visible light, it is desirable to use a light absorbing film capable of absorbing visible light, and in a case where the light emitting elements 53 emits infrared light, it is desirable to use a light absorbing film capable of absorbing infrared light.

In the modification illustrated in B of Fig. 24, the protrusion 72 is a dummy lens, and the protrusion 56 is a dummy light emitting element. The dummy light emitting element of the present modification has a similar structure to that of the light emitting element 53, but is a protrusion 56 that is not used as the light emitting element 53. Therefore, the dummy light emitting element may not be electrically connected to, for example, the anode electrode 54 or the switch SW (see Fig. 3). Furthermore, the dummy lens of the present modification has a similar structure to that of the lens 71, but is a protrusion 72 that is not used as the lens 71. Therefore, the dummy lens of the present modification is arranged at a position corresponding to the dummy light emitting element, that is, in the Z direction of the dummy light emitting element. According to the present modification, since the protrusion 72 is a dummy lens, the protrusion 72 can be easily formed simultaneously with the lenses 71. Furthermore, according to the present modification, since the protrusion 56 is a dummy light emitting element, the protrusion 56 can be easily formed simultaneously with the light emitting elements 53.

In the modification illustrated in A of Fig. 24, the protrusion forming film 75 is a film (for example, an organic film) having elasticity. Therefore, when the collet 83 comes into contact with the protrusion 72, the protrusion 72 is deformed and functions as a cushioning material. As a result, the pressure from the collet 83 to the substrate 51 can be dispersed, and the substrate 51 can be stably mounted on the substrate 61.

In the modification illustrated in B of Fig. 24, the protrusion forming film 57 is a film (for example, an organic film) having elasticity. Therefore, when the collet 84 comes into contact with the protrusion 56, the protrusion 56 is deformed and functions as a cushioning material. As a result, the pressure from the collet 84 to the substrate 51 can be dispersed, and the substrate 51 can be stably mounted on the substrate 61.

Note that the protrusion forming film 75 may be a film (for example, an inorganic film) having rigidity. As a result, when the collet 83 comes into contact with the protrusion 72, it is possible to suppress the substrate 51 from being warped by the pressure from the collet 83. It similarly applies to the protrusion forming film 57.

Furthermore, the protrusion forming film 75 may be a film having a water barrier property. As a result, it is possible to prevent water from entering the lens region 81a and the lenses 71 and the light emitting elements 53 from coming into contact with water. It similarly applies to the protrusion forming film 57.

As described above, in the light emitting device 1 of the present embodiment, the height of the uppermost portion of the antireflection film 73 (first portion Z1) on each lens 71 is equal to or less than the height of the uppermost portion of the protrusion forming film 75 (second portion Z2) in the protrusion 72. Therefore, according to the present embodiment, the lenses 71 can be provided on the substrate 51 in a suitable manner. For example, when the substrate 51 is adsorbed and mounted on the substrate 61, by holding the substrate 51 by adsorption in the second portion X2, it is possible to suppress damage to the lenses 71 due to application of pressure to the lenses 71 and to suppress difficulty in adsorption of the substrate 51 due to the lenses 71.

Furthermore, in the light emitting device 1 of the present embodiment, the height of the lowermost portion of each light emitting element 53 is equal to or higher than the height of the lowermost portion of the protrusion 56. Therefore, according to the present embodiment, the light emitting elements 53 can be provided on the substrate 51 in a suitable manner. For example, when the substrate 51 is adsorbed and mounted on the substrate 61, by holding the substrate 51 by adsorption at the protrusion 56, it is possible to suppress damage to the light emitting elements 53 due to application of pressure to the light emitting elements 53 and to suppress difficulty in adsorption of the substrate 51 due to the light emitting elements 53.

### (12th to 15th Embodiments)

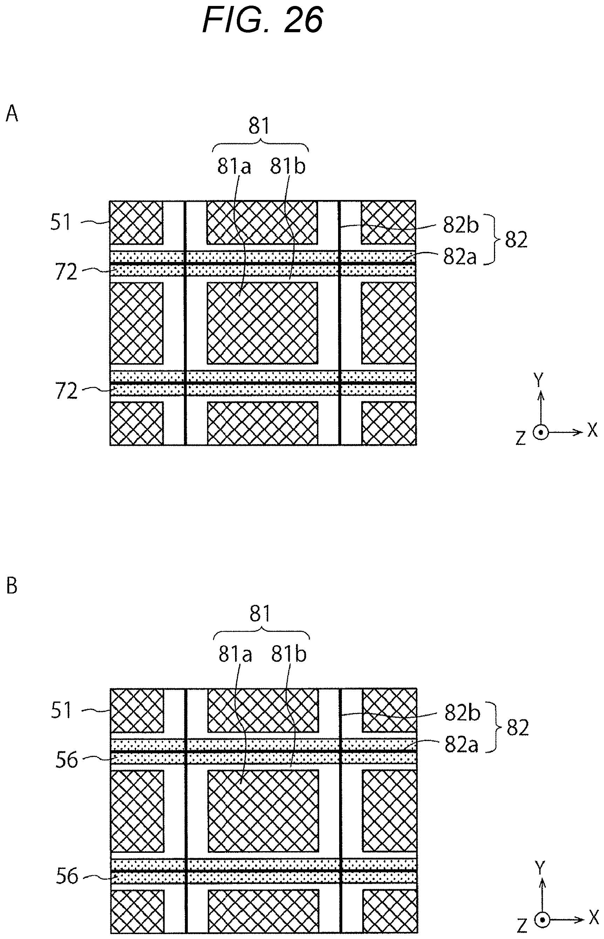

Fig. 26 is a plan view illustrating a structure of a substrate 51 of a light emitting device 1 of a 12th embodiment. A of Fig. 26 illustrates a plurality of protrusions 72 provided on the substrate 51 before dicing. B of Fig. 26 illustrates a plurality of protrusions 56 provided on the substrate 51 before dicing.

Each protrusion 72 of the present embodiment is arranged in or near one scribe line 82a extending in the X direction (A of Fig. 26). When the substrate 51 of the present embodiment is diced, each chip region 81 includes a protrusion 72 extending linearly along one side of the back surface S2 of the substrate 51 and a protrusion 72 extending linearly along another side of the back surface S2 of the substrate 51.

Furthermore, each protrusion 56 of the present embodiment is also arranged in or near one scribe line 82a extending in the X direction (B of Fig. 26). When the substrate 51 of the present embodiment is diced, each chip region 81 includes a protrusion 56 extending linearly along one side of the front surface S1 of the substrate 51 and a protrusion 56 extending linearly along another side of the front surface S1 of the substrate 51.

As described above, the substrate 51 of the present embodiment includes the plurality of protrusions 56 on the front surface S1 of the substrate 51 and the plurality of protrusions 72 on the back surface S2 of the substrate 51. The protrusion 56 and the protrusion 72 of the present embodiment have the same shape in plan view and are arranged at the same position in plan view. Therefore, the protrusion 56 and the protrusion 72 of the present embodiment are arranged so as to overlap each other in the Z direction.

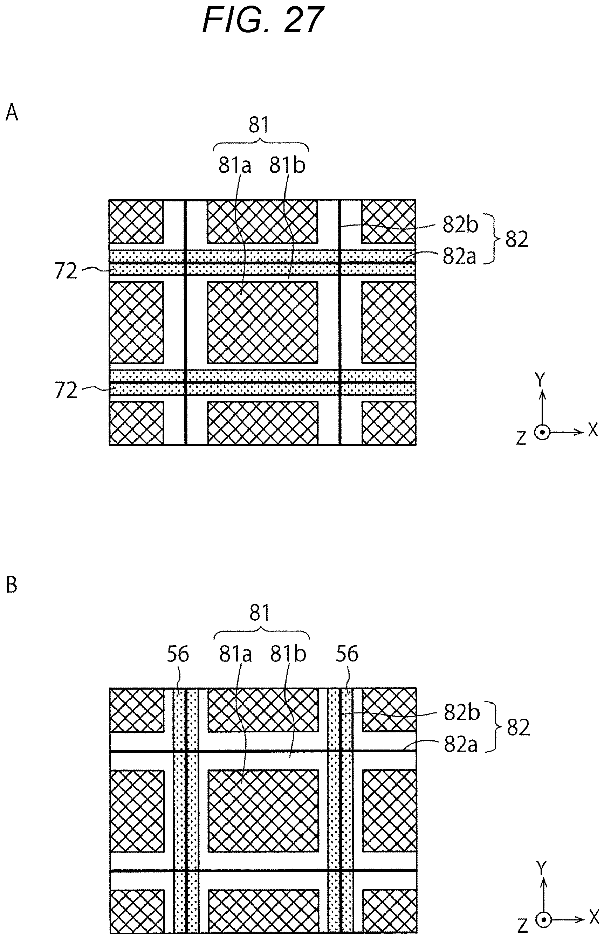

Fig. 27 is a plan view illustrating a structure of a substrate 51 of a light emitting device 1 of a 13th embodiment. A of Fig. 27 illustrates a plurality of protrusions 72 provided on the substrate 51 before dicing. B of Fig. 27 illustrates a plurality of protrusions 56 provided on the substrate 51 before dicing.

Each protrusion 72 of the present embodiment is arranged in or near one scribe line 82a extending in the X direction (A of Fig. 27). Meanwhile, each protrusion 56 of the present embodiment is arranged in or near one scribe line 82a extending in the Y direction (B of Fig. 27). The protrusion 56 and the protrusion 72 of the present embodiment have different shapes in plan view.

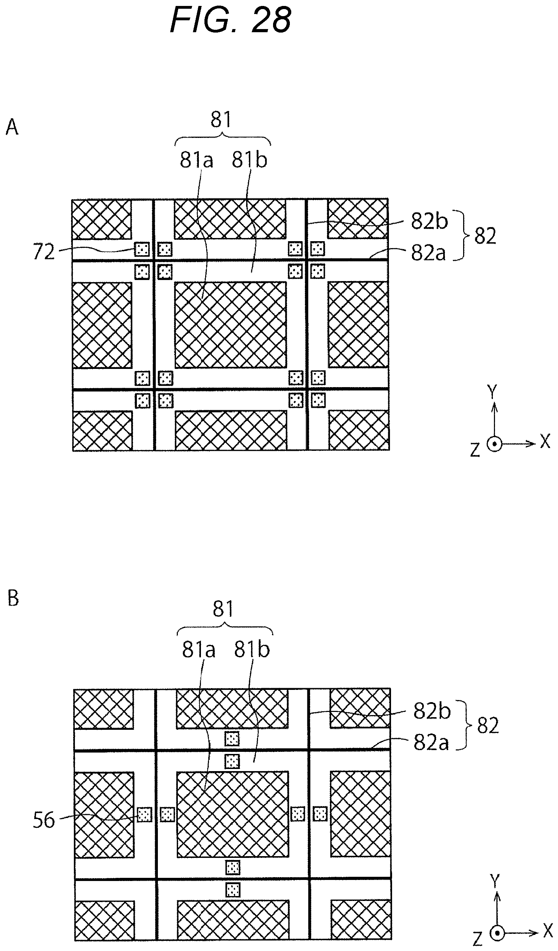

Fig. 28 is a plan view illustrating a structure of a substrate 51 of a light emitting device 1 of a 14th embodiment. A of Fig. 28 illustrates a plurality of protrusions 72 provided on the substrate 51 before dicing. B of Fig. 28 illustrates a plurality of protrusions 56 provided on the substrate 51 before dicing.

Each protrusion 72 of the present embodiment is arranged in the vicinity of each intersection of the scribe line 82a and the scribe line 82b (A of Fig. 28). When the substrate 51 of the present embodiment is diced, each chip region 81 includes four protrusions 72 provided at four corners of the back surface S2 of the substrate 51.

Meanwhile, each protrusion 56 of the present embodiment is arranged in the vicinity of the scribe line 82a or the scribe line 82b (B of Fig. 28). When the substrate 51 of the present embodiment is diced, each chip region 81 includes four protrusions 56 provided on four sides of the front surface S1 of the substrate 51.

The protrusions 56 and the protrusions 72 of the present embodiment have the same shape in plan view, but are arranged at different positions in plan view. Note that the protrusions 56 may be arranged in the same layout as the protrusions 72 illustrated in A of Fig. 28. Meanwhile, the protrusions 72 may be arranged in the same layout as the protrusions 56 illustrated in B of Fig. 28.

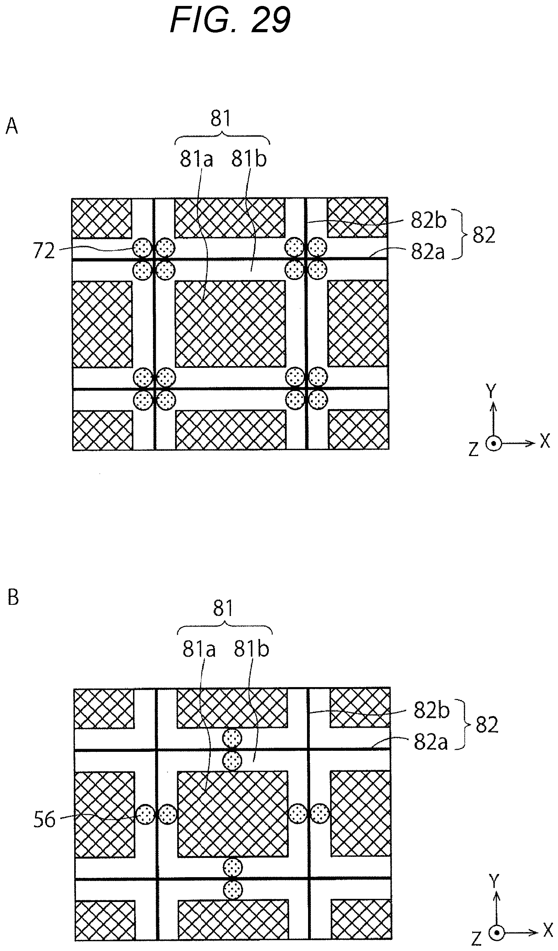

Fig. 29 is a plan view illustrating a structure of a substrate 51 of a light emitting device 1 of a 15th embodiment. A of Fig. 29 illustrates a plurality of protrusions 72 provided on the substrate 51 before dicing. B of Fig. 29 illustrates a plurality of protrusions 56 provided on the substrate 51 before dicing.

Similarly to each protrusion 72 of the 14th embodiment, each protrusion 72 of the present embodiment is arranged in the vicinity of each intersection of the scribe line 82a and the scribe line 82b (A of Fig. 29). However, while each protrusion 72 of the 14th embodiment has a quadrangular planar shape, each protrusion 72 of the present embodiment has a circular planar shape.

Meanwhile, similarly to each protrusion 56 of the 14th embodiment, each protrusion 56 of the present embodiment is arranged in the vicinity of the scribe line 82a or the scribe line 82b (B of Fig. 29). However, while each protrusion 56 of the 14th embodiment has a quadrangular planar shape, each protrusion 56 of the present embodiment has a circular planar shape.

The protrusions 56 and the protrusions 72 of the present embodiment have the same shape in plan view, but are arranged at different positions in plan view. Note that the protrusions 56 may be arranged in the same layout as the protrusions 72 illustrated in A of Fig. 29. Meanwhile, the protrusions 72 may be arranged in the same layout as the protrusions 56 illustrated in B of Fig. 29.

### (16th Embodiment)

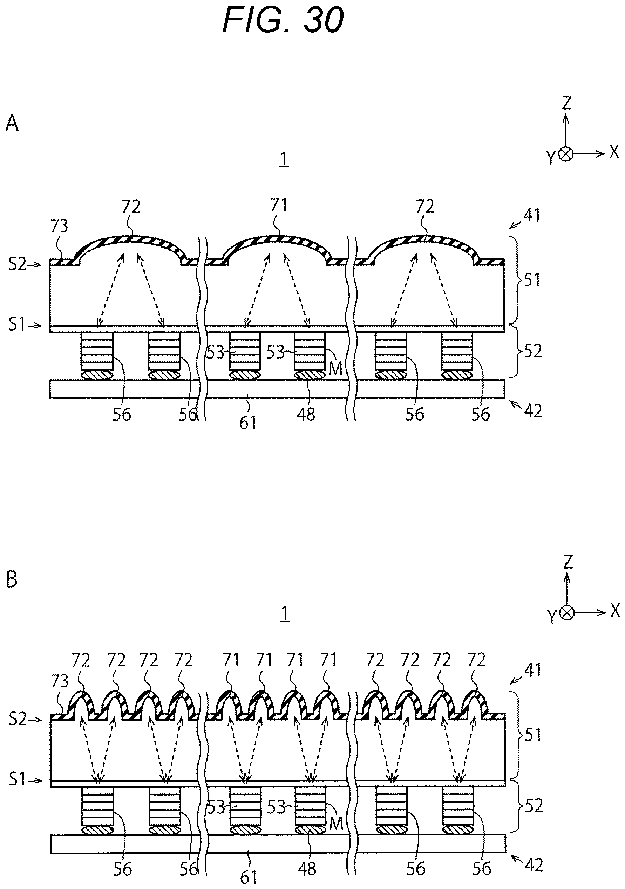

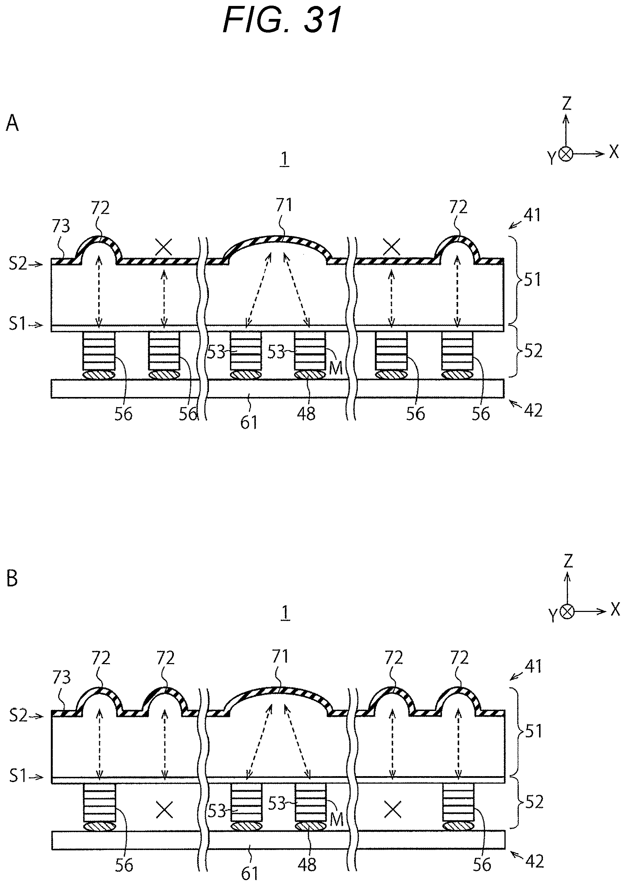

A light emitting device 1 of a 16th embodiment corresponds to a light emitting device 1 of a modification of the 11th to 15th embodiments. Hereinafter, various examples of the light emitting device 1 of the 16th embodiment will be described with reference to Figs. 30 and 31.

Figs. 30 and 31 are cross-sectional views illustrating a structure of the light emitting device 1 of the 16th embodiment.

In the substrate 51 in A of Fig. 30, the light emitting elements 53 and the lenses 71 correspond to each other at N : 1 (N is an integer of 2 or more). Therefore, light emitted from N light emitting elements 53 is incident on one lens 71. In the substrate 51 in A of Fig. 30, the dummy light emitting elements (protrusions 56) and the dummy lenses (protrusions 72) also correspond to each other at N : 1. As a result, for example, it is easy to form the dummy light emitting elements simultaneously with the light emitting elements 53 and to form the dummy lenses simultaneously with the lenses 71.

In the substrate 51 in B of Fig. 30, the light emitting elements 53 and the lenses 71 correspond to each other at 1 : N. Therefore, light emitted from one light emitting element 53 is incident on N lenses 71. In the substrate 51 in B of Fig. 30, the dummy light emitting elements (protrusions 56) and the dummy lenses (protrusions 72) also correspond to each other at 1 : N. As a result, for example, it is easy to form the dummy light emitting elements simultaneously with the light emitting elements 53 and to form the dummy lenses simultaneously with the lenses 71.

In the substrate 51 in A of Fig. 31, the light emitting elements 53 and the lenses 71 correspond to each other at N : 1, and many dummy light emitting elements (protrusions 56) and dummy lenses (protrusions 72) correspond to each other at 1 : 1. However, some dummy light emitting elements do not correspond to dummy lenses. As described above, the light emitting device 1 of the present embodiment may include a dummy light emitting element that does not correspond to the dummy lens.

In the substrate 51 in B of Fig. 31, the light emitting elements 53 and the lenses 71 correspond to each other at N : 1, and many dummy light emitting elements (protrusions 56) and dummy lenses (protrusions 72) correspond to each other at 1 : 1. However, some dummy lenses do not correspond to dummy light emitting elements. As described above, the light emitting device 1 of the present embodiment may include a dummy lens that does not correspond to the dummy light emitting element.

### (17th Embodiment)

The method for manufacturing a light emitting device 1 of a 17th embodiment can be implemented by combining the first or second example and the third or fourth example. In the first example, the protrusions 56 including the dummy light emitting elements are formed. In the second example, the protrusions 56 including the protrusion forming film 57 are formed. In the third example, the protrusions 72 including the dummy lenses are formed. In the fourth example, the protrusions 72 including the protrusion forming film 75 are formed.

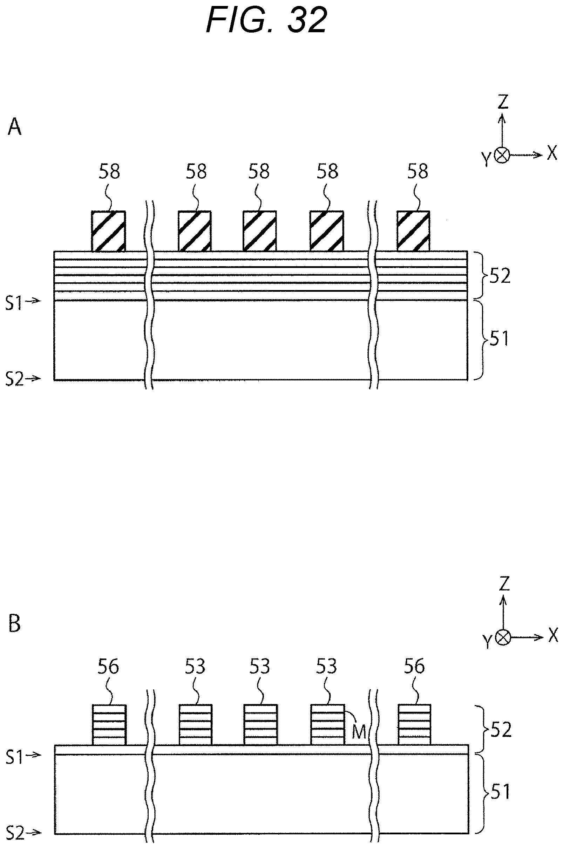

Fig. 32 is a cross-sectional view illustrating a first example of the method for manufacturing the light emitting device 1 of the 17th embodiment.

First, the laminated film 52 is formed on the substrate 51 with the front surface S1 of the substrate 51 facing upward (A of Fig. 32). Next, a resist film 58 is formed on the laminated film 52, and the resist film 58 is patterned by photolithography and etching (A of Fig. 32).

Next, the laminated film 52 is etched using the resist film 58 as a mask (B of Fig. 32). As a result, a part of the laminated film 52 is processed into the light emitting elements 53 or the dummy light emitting elements (protrusions 56). According to the first example, the light emitting elements 53 and the protrusions 56 can be formed in the same process.

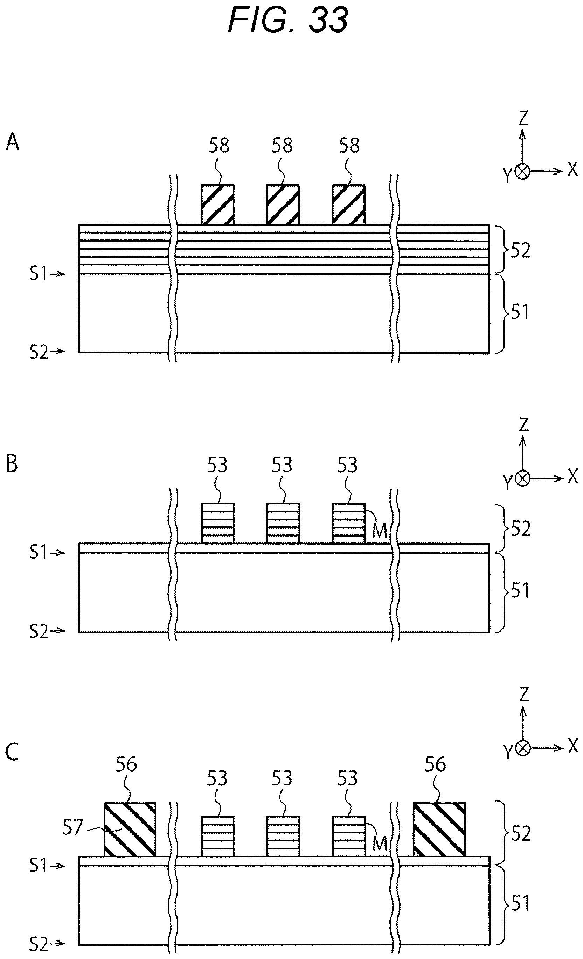

Fig. 33 is a cross-sectional view illustrating a second example of the method for manufacturing the light emitting device 1 of the 17th embodiment.

First, the laminated film 52 is formed on the substrate 51 with the front surface S1 of the substrate 51 facing upward (A of Fig. 32). Next, a resist film 58 is formed on the laminated film 52, and the resist film 58 is patterned by photolithography and etching (A of Fig. 33).

Next, the laminated film 52 is etched using the resist film 58 as a mask (B of Fig. 33). As a result, a part of the laminated film 52 is processed into the light emitting elements 53.

Next, the protrusion forming film 57 is formed on the substrate 51 with the laminated film 52 interposed therebetween, and the protrusion forming film 57 is etched (C of Fig. 33). As a result, the protrusions 56 are constituted by the protrusion forming film 57. According to the second example, the light emitting elements 53 and the protrusions 56 can be formed in different processes.

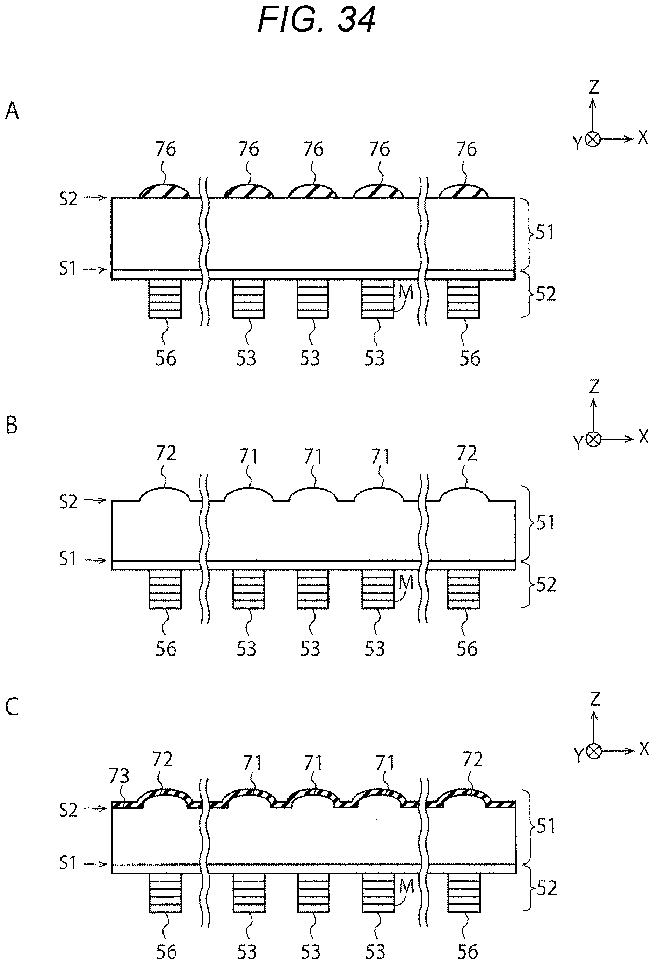

Fig. 34 is a cross-sectional view illustrating a third example of the method for manufacturing the light emitting device 1 of the 17th embodiment.

First, a resist film 76 is formed on the substrate 51 with the back surface S2 of the substrate 51 facing upward (A of Fig. 34). Next, the resist film 76 is patterned by photolithography and etching (A of Fig. 34). The resist film 76 in this case is patterned in a shape similar to convex lenses.

Next, the substrate 51 is etched using the resist film 76 as a mask (B of Fig. 34). As a result, part of the substrate 51 is processed into the lenses 71 or the dummy lenses (protrusions 72). According to the third example, the lenses 71 and the protrusions 72 can be formed in the same process.

Next, the antireflection film 73 is formed on the substrate 51 (C of Fig. 34). As a result, the lenses 71 and the protrusions 72 are covered with the antireflection film 73, and the above-described first portion X1 and second portion X2 are formed (see A of Fig. 4).

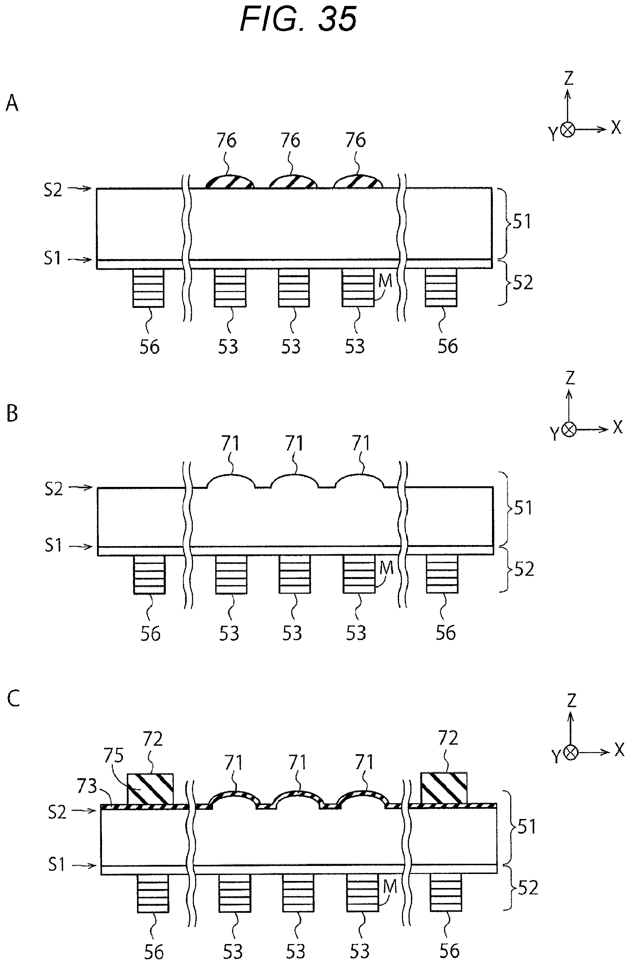

Fig. 35 is a cross-sectional view illustrating a fourth example of the method for manufacturing the light emitting device 1 of the 17th embodiment.

First, a resist film 76 is formed on the substrate 51 with the back surface S2 of the substrate 51 facing upward (A of Fig. 35). Next, the resist film 76 is patterned by photolithography and etching (A of Fig. 35). The resist film 76 in this case is patterned in a shape similar to convex lenses.

Next, the substrate 51 is etched using the resist film 76 as a mask (B of Fig. 35). As a result, part of the substrate 51 is processed into the lenses 71.

Next, the antireflection film 73 is formed on the substrate 51 (C of Fig. 35). As a result, the lenses 71 are covered with the antireflection film 73. Next, the protrusion forming film 75 is formed on the substrate 51 with the antireflection film 73 interposed therebetween, and the protrusion forming film 75 is etched (C of Fig. 35). As a result, the protrusions 72 is constituted by the protrusion forming film 75, and the above-described first portion Z1 and second portion Z2 are formed (see A of Fig. 21). According to the fourth example, the lenses 53 and the protrusions 72 can be formed in different processes.

The substrate 51 after the process illustrated in C of Fig. 34 or C of Fig. 35 is mounted on the substrate 61 by, for example, the process illustrated in D of Fig. 23. In this way, the light emitting device 1 of the present embodiment is manufactured.

According to the present embodiment, it is possible to manufacture various light emitting devices 1 described in the 11th to 16th embodiments. For example, the light emitting device 1 including the dummy light emitting elements can be manufactured by using the first example. Furthermore, the light emitting device 1 including the dummy lenses can be manufactured by using the third example.

Note that the light emitting device 1 of the first to 17th embodiments is used as a light source of a distance measuring device, but may be used in other modes. For example, the light emitting device 1 of these embodiments may be used as a light source of an optical apparatus such as a printer, or may be used as an illumination device.

Although the embodiments of the present disclosure have been described above, these embodiments may be implemented with various modifications without departing from the gist of the present disclosure. For example, two or more embodiments may be implemented in combination.

Note that the present disclosure can also have the following configurations.
(1) A light emitting device including:
   a first substrate;
   a light emitting element provided on a lower surface of the first substrate;
   a lens provided on an upper surface of the first substrate;
   a first protrusion provided on the upper surface of the first substrate; and
   a first film provided on the upper surface of the first substrate, the first film including a first portion disposed on the lens or forming the lens, and a second portion disposed on the first protrusion or forming the first protrusion,
   in which a height of an uppermost portion of the first portion is equal to or less than a height of an uppermost portion of the second portion.
(2) The light emitting device according to (1), in which the lens is a convex lens, a concave lens, a Fresnel lens, a binary lens, or a flat lens.
(3) The light emitting device according to (1),
   in which one or more of the light emitting elements are provided on the lower surface of the first substrate,
   one or more of the lenses are provided on the upper surface of the first substrate, and
   the light emitting element and the lens correspond to each other at 1 : 1, N : 1, or 1 : N (N is an integer of 2 or more).
(4) The light emitting device according to (1), in which the first protrusion has a shape annularly surrounding the lens.
(5) The light emitting device according to (1), further including a plurality of first protrusions provided on a plurality of corners or sides of the upper surface of the first substrate as the first protrusion.
(6) The light emitting device according to (1), in which the first protrusion has a linear shape extending along one side of the upper surface of the first substrate.
(7) The light emitting device according to (1), in which the first protrusion has an L-shape extending along two sides of the upper surface of the first substrate.
(8) The light emitting device according to (1), in which the first protrusion includes a dummy lens.
(9) The light emitting device according to (1), in which the first film includes an antireflection film provided on the lens.
(10) The light emitting device according to (9), in which the first film further includes a light absorbing film, an inorganic film, or an organic film.
(11) The light emitting device according to (10), in which the light absorbing film, the inorganic film, or the organic film is provided on the antireflection film.
(12) The light emitting device according to (1), further including
   a second protrusion provided on the lower surface of the first substrate,
   in which a height of a lowermost portion of the light emitting element is equal to or higher than a height of a lowermost portion of the second protrusion.
(13) The light emitting device according to (12), in which the second protrusion has a shape annularly surrounding the light emitting element.
(14) The light emitting device according to (12), further including a plurality of second protrusions provided on a plurality of corners or sides of the lower surface of the first substrate as the second protrusion.
(15) The light emitting device according to (12), in which the second protrusion has a linear shape extending along one side of the lower surface of the first substrate.
(16) The light emitting device according to (12), in which the second protrusion includes a dummy light emitting element.
(17) The light emitting device according to (12), further including a second film provided on the lower surface of the first substrate and forming the second protrusion.
(18) The light emitting device according to (17), in which the second film includes a light absorbing film, an inorganic film, or an organic film.
(19) The light emitting device according to (1), in which the first substrate is a semiconductor substrate containing gallium (Ga) and arsenic (As).
(20) The light emitting device according to (1), in which light emitted from the light emitting element passes through the first substrate from the lower surface to the upper surface of the first substrate, and enters the lens.
(21) The light emitting device according to (1), further including a second substrate on which the first substrate is mounted with the light emitting element interposed therebetween.
(22) The light emitting device according to (21), in which the second substrate is a semiconductor substrate containing silicon (Si).
(23) A light emitting device including:
   a first substrate;
   a light emitting element provided on a lower surface of the first substrate;
   a lens provided on an upper surface of the first substrate; and
   a first protrusion provided on the upper surface of the first substrate,
   in which a height of an uppermost portion of the lens is equal to or less than a height of an uppermost portion of the first protrusion.
(24) A method for manufacturing a light emitting device, the method including:
   forming a light emitting element on a lower surface of a first substrate;
   forming a lens on an upper surface of the first substrate;
   forming a first protrusion on the upper surface of the first substrate; and
   forming a first film including a first portion and a second portion on the upper surface of the first substrate,
   in which the first film is formed such that the first portion is disposed on the lens or forms the lens, and the second portion is disposed on the first protrusion or forms the first protrusion, and
   the first film is formed such that a height of an uppermost portion of the first portion is equal to or less than a height of an uppermost portion of the second portion.
(25) The method for manufacturing the light emitting device according to (24), further including dicing the first substrate into a plurality of chips after formation of the lens, the first protrusion, and the first film.
(26) The method for manufacturing the light emitting device according to (25), in which a part of the first protrusion is formed in a dicing region of the first substrate.
(27) The method for manufacturing the light emitting device according to (25), in which at least a part of the first protrusion is formed in a region other than a dicing region of the first substrate.
(28) The method for manufacturing the light emitting device according to (25), further including:
   bringing a first substrate holding device into contact with the first film after dicing the first substrate and holding the first substrate by the first substrate holding device; and
   mounting the first substrate held by the first substrate holding device on a second substrate with the light emitting element interposed therebetween.
(29) The method for manufacturing the light emitting device according to (28), in which the first substrate holding device holds the first substrate to be in contact with the second portion and not to be in contact with the first portion.
(30) The method for manufacturing the light emitting device according to (24), further including
   forming a second protrusion on the lower surface of the first substrate,
   in which the light emitting element and the second protrusion are formed such that a height of a lowermost portion of the light emitting element is equal to or higher than a height of a lowermost portion of the second protrusion.
(31) The method for manufacturing the light emitting device according to (30), in which the second protrusion is formed to include a second film formed on the lower surface of the first substrate.
(32) The method for manufacturing the light emitting device according to (30), further including dicing the first substrate into a plurality of chips after formation of the light emitting element, the lens, the first protrusion, the first film, and the second protrusion.
(33) The method for manufacturing the light emitting device according to (32), further including:
   bringing a second substrate holding device into contact with the second protrusion after dicing the first substrate and holding the first substrate by the second substrate holding device; and
   mounting the first substrate held by the second substrate holding device on a second substrate with the light emitting element interposed therebetween.
(34) The method for manufacturing the light emitting device according to (33), in which the second substrate holding device holds the first substrate to be in contact with the second protrusion and not to be in contact with the light emitting element.
(35) A method for manufacturing a light emitting device, the method including:
   forming a light emitting element on a lower surface of a first substrate;
   forming a lens on an upper surface of the first substrate; and
   forming a first protrusion on the upper surface of the first substrate,
   in which the lens and the first protrusion are formed such that a height of an uppermost portion of the lens is equal to or less than a height of an uppermost portion of the first protrusion.

### REFERENCE SIGNS LIST

- 1: Light emitting device
- 2: Imaging device
- 3: Control device
- 11: Light emitting unit
- 12: Drive circuit
- 13: Power supply circuit
- 14: Light-emitting side optical system
- 21: Image sensor
- 22: Image processing unit
- 23: Imaging side optical system
- 31: Distance measurement unit
- 41: LD chip
- 42: LDD substrate
- 43: Mounting substrate
- 44: Heat dissipation substrate
- 45: Correction lens holding unit
- 46: Correction lens
- 47: Wiring
- 48: Bump
- 51: Substrate
- 52: Laminated film
- 53: Light emitting element
- 54: Anode electrode
- 55: Cathode electrode
- 56: Protrusion
- 57: Protrusion forming film
- 58: Resist film
- 61: Substrate
- 62: Connection pad
- 71: Lens
- 72: Protrusion
- 73: Antireflection film
- 74: Semiconductor film
- 75: Protrusion forming film
- 76: Resist film
- 81: Chip region
- 81a: Lens region
- 81b: Peripheral region
- 82: Scribe region
- 82a: Scribe line
- 82b: Scribe line
- 83: Collet
- 84: Collet

## Claims

1. A light emitting device comprising:
a first substrate;
a light emitting element provided on a lower surface of the first substrate;
a lens provided on an upper surface of the first substrate;
a first protrusion provided on the upper surface of the first substrate; and
a first film provided on the upper surface of the first substrate, the first film including a first portion disposed on the lens or forming the lens, and a second portion disposed on the first protrusion or forming the first protrusion,
wherein a height of an uppermost portion of the first portion is equal to or less than a height of an uppermost portion of the second portion.

2. The light emitting device according to claim 1, wherein the lens is a convex lens, a concave lens, a Fresnel lens, a binary lens, or a flat lens.

3. The light emitting device according to claim 1,
wherein one or more of the light emitting elements are provided on the lower surface of the first substrate,
one or more of the lenses are provided on the upper surface of the first substrate, and
the light emitting element and the lens correspond to each other at 1 : 1, N : 1, or 1 : N (N is an integer of 2 or more).

4. The light emitting device according to claim 1, wherein the first protrusion has a shape annularly surrounding the lens.

5. The light emitting device according to claim 1, further comprising a plurality of first protrusions provided on a plurality of corners or sides of the upper surface of the first substrate as the first protrusion.

6. The light emitting device according to claim 1, wherein the first protrusion has a linear shape extending along one side of the upper surface of the first substrate.

7. The light emitting device according to claim 1, wherein the first protrusion has an L-shape extending along two sides of the upper surface of the first substrate.

8. The light emitting device according to claim 1, wherein the first protrusion includes a dummy lens.

9. The light emitting device according to claim 1, wherein the first film includes an antireflection film provided on the lens.

10. The light emitting device according to claim 9, wherein the first film further includes a light absorbing film, an inorganic film, or an organic film.

11. The light emitting device according to claim 10, wherein the light absorbing film, the inorganic film, or the organic film is provided on the antireflection film.

12. The light emitting device according to claim 1, further comprising
a second protrusion provided on the lower surface of the first substrate,
wherein a height of a lowermost portion of the light emitting element is equal to or higher than a height of a lowermost portion of the second protrusion.

13. The light emitting device according to claim 12, wherein the second protrusion has a shape annularly surrounding the light emitting element.

14. The light emitting device according to claim 12, further comprising a plurality of second protrusions provided on a plurality of corners or sides of the lower surface of the first substrate as the second protrusion.

15. The light emitting device according to claim 12, wherein the second protrusion has a linear shape extending along one side of the lower surface of the first substrate.

16. The light emitting device according to claim 12, wherein the second protrusion includes a dummy light emitting element.

17. The light emitting device according to claim 12, further comprising a second film provided on the lower surface of the first substrate and forming the second protrusion.

18. The light emitting device according to claim 17, wherein the second film includes a light absorbing film, an inorganic film, or an organic film.

19. The light emitting device according to claim 1, wherein the first substrate is a semiconductor substrate containing gallium (Ga) and arsenic (As).

20. The light emitting device according to claim 1, wherein light emitted from the light emitting element passes through the first substrate from the lower surface to the upper surface of the first substrate, and enters the lens.

21. The light emitting device according to claim 1, further comprising a second substrate on which the first substrate is mounted with the light emitting element interposed therebetween.

22. The light emitting device according to claim 21, wherein the second substrate is a semiconductor substrate containing silicon (Si).

23. A light emitting device comprising:
a first substrate;
a light emitting element provided on a lower surface of the first substrate;
a lens provided on an upper surface of the first substrate; and
a first protrusion provided on the upper surface of the first substrate,
wherein a height of an uppermost portion of the lens is equal to or less than a height of an uppermost portion of the first protrusion.

24. A method for manufacturing a light emitting device, the method comprising:
forming a light emitting element on a lower surface of a first substrate;
forming a lens on an upper surface of the first substrate;
forming a first protrusion on the upper surface of the first substrate; and
forming a first film including a first portion and a second portion on the upper surface of the first substrate,
wherein the first film is formed such that the first portion is disposed on the lens or forms the lens, and the second portion is disposed on the first protrusion or forms the first protrusion, and
the first film is formed such that a height of an uppermost portion of the first portion is equal to or less than a height of an uppermost portion of the second portion.

25. The method for manufacturing the light emitting device according to claim 24, further comprising dicing the first substrate into a plurality of chips after formation of the lens, the first protrusion, and the first film.

26. The method for manufacturing the light emitting device according to claim 25, wherein a part of the first protrusion is formed in a dicing region of the first substrate.

27. The method for manufacturing the light emitting device according to claim 25, wherein at least a part of the first protrusion is formed in a region other than a dicing region of the first substrate.

28. The method for manufacturing the light emitting device according to claim 25, further comprising:
bringing a first substrate holding device into contact with the first film after dicing the first substrate and holding the first substrate by the first substrate holding device; and
mounting the first substrate held by the first substrate holding device on a second substrate with the light emitting element interposed therebetween.

29. The method for manufacturing the light emitting device according to claim 28, wherein the first substrate holding device holds the first substrate to be in contact with the second portion and not to be in contact with the first portion.

30. The method for manufacturing the light emitting device according to claim 24, further comprising
forming a second protrusion on the lower surface of the first substrate,
wherein the light emitting element and the second protrusion are formed such that a height of a lowermost portion of the light emitting element is equal to or higher than a height of a lowermost portion of the second protrusion.

31. The method for manufacturing the light emitting device according to claim 30, wherein the second protrusion is formed to include a second film formed on the lower surface of the first substrate.

32. The method for manufacturing the light emitting device according to claim 30, further comprising dicing the first substrate into a plurality of chips after formation of the light emitting element, the lens, the first protrusion, the first film, and the second protrusion.

33. The method for manufacturing the light emitting device according to claim 32, further comprising:
bringing a second substrate holding device into contact with the second protrusion after dicing the first substrate and holding the first substrate by the second substrate holding device; and
mounting the first substrate held by the second substrate holding device on a second substrate with the light emitting element interposed therebetween.

34. The method for manufacturing the light emitting device according to claim 33, wherein the second substrate holding device holds the first substrate to be in contact with the second protrusion and not to be in contact with the light emitting element.

35. A method for manufacturing a light emitting device, the method comprising:
forming a light emitting element on a lower surface of a first substrate;
forming a lens on an upper surface of the first substrate; and
forming a first protrusion on the upper surface of the first substrate,
wherein the lens and the first protrusion are formed such that a height of an uppermost portion of the lens is equal to or less than a height of an uppermost portion of the first protrusion.
